(19) Europäisches Patentamt / European Patent Office / Office européen des brevets

(11) **EP 1 816 677 A1**

(12) # EUROPEAN PATENT APPLICATION
published in accordance with Art. 158(3) EPC

(43) Date of publication:
08.08.2007 Bulletin 2007/32

(51) Int Cl.:
*H01L 27/14* (2006.01)   *G03B 11/00* (2006.01)

(21) Application number: 05782240.5

(22) Date of filing: 07.09.2005

(86) International application number:
PCT/JP2005/016414

(87) International publication number:
WO 2006/028128 (16.03.2006 Gazette 2006/11)

(84) Designated Contracting States:
DE FR

(30) Priority: 09.09.2004 JP 2004262869
30.09.2004 JP 2004288646
29.10.2004 JP 2004316394

(71) Applicant: MATSUSHITA ELECTRIC INDUSTRIAL
CO., LTD.
Osaka 571-8501 (JP)

(72) Inventors:
• KASANO, Masahiro,
c/o Matsushita Electric Industrial Co., Ltd.
3-7 Shiromi 1-chome, Chuo-ku,
Osaka-shi, Osaka 540-6319 (JP)
• YAMAGUCHI, Takumi,
c/o Matsushita Electric Industrial Co., Ltd.
3-7 Shiromi 1-chome, Chuo-ku,
Osaka-shi, Osaka 540-6319 (JP)

(74) Representative: Crawford, Andrew Birkby et al
A.A. Thornton & Co.,
235 High Holborn
London WC1V 7LE (GB)

(54) **SOLID-STATE IMAGE PICKUP ELEMENT**

(57)     An object of the present invention is to provide a solid-state image sensor including a filter membrane that has excellent light resistance and can be thinned. A solid-state image sensor 1 having a plurality of pixels, wherein each of the plurality of pixels includes a filter membrane 21 for transmitting light of a predetermined color, and a photoelectric conversion unit 17 for converting the light transmitted through the filter membrane 21 into a charge; the filter membrane 21 is a single layer film composed of an inorganic material; and an optical thickness of the single layer film is smaller than a thickness equivalent to one half of a wavelength of the predetermined color, by a thickness corresponding to an amount of the light of the predetermined color absorbed by the inorganic material.

FIG.2

EP 1 816 677 A1

## Description

## Technical Field

The present invention relates to a solid-state image sensor used for a digital camera and the like, and especially relates to a filter membrane for color separation.

## Background Art

A solid-state image sensor is composed of a plurality of pixels, and each of the plurality of pixels includes a filter membrane and a photoelectric conversion unit. The filter membrane is provided for color separation of light. For example, a filter membrane of each of colors of red (R), green (G), and blue (B) is provided as a primary color filter, and a filter membrane of each of colors of cyan (C), magenta (M), yellow (Y), and green (G) is provided as a complementary color filter. The photoelectric conversion unit converts light transmitted through the filter membrane into a charge. The converted charge amount is externally outputted as a signal corresponding to the amount of received light of the photoelectric conversion unit. (a patent document 1).

A conventional filter membrane is composed of a transparent resin and the like such as an acrylic resin in which a pigment and a dye as an organic material are dispersed (a patent document 2). In other words, color separation can be realized by using a pigment and a dye according to each of the colors.
Patent Document 1 : Japanese Published Patent Application No. H05-6986
Patent Document 2: Japanese Published Patent Application No. H07-311310

## Disclosure of the Invention

## Problems the Invention is going to Solve

However, the filter membrane has the following problem.
A first problem is that light resistance is not enough because the filter membrane is composed of an organic material. For example, an organic pigment has a characteristic of being subjected to color fading by being exposed to light. If color fading occurs, color separation cannot be performed properly because a transmission characteristic of the filter membrane changes.
A second problem is that it is difficult to thin the filter membrane that is composed of a dispersed pigment and the like. Regarding to this kind of filter membrane, the smaller a film thickness of the filter membrane is, the higher transparency is. Therefore, a color separation characteristic of the filter membrane degrades. When a pigment is used, it is restricted to thin the filter membrane because of a particle size of a pigment. A color mixture among a plurality of pixels can be effectively prevented by thinning a filter membrane. Because a color mixture is likely to occur with miniaturization of pixels in recent years, a film thickness of a filter membrane is increasingly required to be smaller.

An object of the present invention is to provide a solid-state image sensor including a filter membrane that has more excellent light resistance than a conventional filter membrane and can be thinned.

## Means of Solving the Problems

The above problem is solved by a solid-state image sensor having a plurality of pixels, wherein each of the plurality of pixels includes a filter membrane for transmitting light of a predetermined color, and a photoelectric conversion unit for converting the light transmitted through the filter membrane into a charge; the filter membrane is a single layer film composed of an inorganic material; and an optical thickness of the single layer film is smaller than a thickness equivalent to one half of a wavelength of the predetermined color, by a thickness corresponding to an amount of the light of the predetermined color absorbed by the inorganic material.

## Effects of the Invention

With the above-stated construction, the filter membrane is composed of an inorganic material. Therefore, the filter membrane has more excellent light resistance than a conventional filter membrane. Also, an optical thickness of the single layer film is smaller than a thickness equivalent to one half of a wavelength of the predetermined color, by a thickness corresponding to an amount of the light of the predetermined color absorbed by the inorganic material. This enables a local maximal value of a light transmittance to appear at a wavelength of the predetermined color in a transmission spectrum of the filter membrane. Therefore, an optical thickness of the filter membrane can be thinned to a thickness equivalent to one half of a wavelength of each color without degrading a color separation characteristic of the filter membrane.

Also, the larger an absorption coefficient of the inorganic material at a light wavelength of the predetermined color is, the smaller the optical thickness of the single layer film is.
This can prevent a transmittance of the filter membrane from being degraded because of a large light absorption coefficient.
Moreover, a composition of the inorganic material is identical for the plurality of pixels.

With the above-stated construction, since each of the filter membranes is composed of a same material, there is no need to manage a material according to colors in a manufacturing process of the filter membrane. Therefore, the manufacturing cost of the filter membrane can be reduced.
Furthermore, a composition of the inorganic material is different according to which of a plurality of colors is to be transmitted; and the shorter a wavelength of each of the colors is, the smaller a refractive index of the inorganic material is.

With the above-stated construction, a difference of a physical thickness of the filter membrane can be small among pixels each having a different color to be transmitted. Therefore, a layer in which the filter membrane is formed can be planarized easily.

Also, a refractive index of the inorganic material is equal to or larger than 3.

Because a refractive index of the filter membrane is equal to or more than 3, a refracting angle is small even if oblique incident light enters in the filter membrane. Therefore, a color mixture among pixels can be prevented.

Moreover, the inorganic material is amorphous silicon, polysilicon, single-crystal silicon, or a material mainly containing silicon.

An absorption coefficient of amorphous silicon, polysilicon, single-crystal silicon, or a material mainly containing silicon is large. Therefore, color separation can be realized even if the filter membrane is extremely thin.

Also, a refractive index of amorphous silicon, polysilicon, single-crystal silicon, or a material mainly containing silicon is about 4 to 5.and larger compared to a normal insulating film and the like (a refractive index of a silicon.dioxide film is 1.46, for example). Therefore, a refracting angle is small even if oblique incident light enters in the filter membrane, and a color mixture among pixels can be prevented.

Moreover, with regard to amorphous silicon, a film can be formed at a low temperature. Therefore, the filter membrane can be formed after a light shielding film such as low-melting aluminum is formed. As a result, a manufacturing procedure can be changed freely. Furthermore, if amorphous silicon is used, a stress onaphotoelectric conversionunit canbe reduced. Therefore, the damage to the photoelectric conversion unit can be reduced.

Furthermore, the inorganic material is titanium oxide, tantalum oxide, or niobium oxide.

With regard to titanium oxide (titanium dioxide and the like), tantalum oxide (tantalum pentoxide and the like) or niobium oxide (niobium pentoxide and the like), a light absorption coefficient is small in an optical wavelength region. Therefore, a transmittance of the filter membrane can be improved. As a result, the solid-state image sensor having a high sensitivity can be realized.

Also, a refractive index of titanium oxide, tantalum oxide or niobium oxide is equal to or larger than 2 that is relatively large in dielectric materials. Therefore, titanium oxide, tantalum oxide or niobium oxide is suitable for a material for forming an interference filter.

Moreover, each of the plurality of pixels further includes an antireflection film that is provided on a main surface of the filter membrane facing a light source and has a smaller refractive index than the filter membrane.

With the above-stated construction, a difference of a refractive index between media through which incident light passes is small, and reflection of incident light on the filter membrane surface decreases. Therefore, the solid-state image sensor having a high sensitivity can be realized. Also, a peak wavelength of a light transmittance of the filter membrane can be controlled by varying a thickness of the antireflection film. As a result, a color separation characteristic and a design freedom can be improved.

Furthermore, the antireflection film is composed of silicon nitride, silicon dioxide, or silicon oxide nitride.

With the above-stated construction, the antireflection film can be manufactured by a semiconductor process. Therefore, the manufacturing cost of the filter membrane can be reduced.

Also, the photoelectric conversion unit is formed in a part of a substrate; each of the plurality of pixels further includes a light shielding film that covers the substrate and has an opening provided in a position corresponding to the photoelectric conversion unit; and the filter membrane is provided between the light shielding film and the substrate.

With the above-stated construction, a light interference between the photoelectric conversion unit and the filter membrane can be prevented. This improves a sensitivity of the solid-state image sensor. Furthermore, the above- stated construction is effective as a method for preventing a color mixture. It is easy to form the filter membrane between the light shielding film and the photoelectric conversion unit because a physical thickness of the filter membrane is extremely thin.

Moreover, each of the plurality of pixels is provided so that a main surface of the filter membrane facing the photoelectric conversion unit is provided on a same plane; each of the plurality of pixels further includes a planarizing layer provided on a main surface of the filter membrane facing a light source; and the larger a physical thickness of the filter membrane is, the smaller a thickness of the planarizing layer is.

With the above-stated construction, a main surface of the planarizing layer facing the light source canbe planarized among pixels. This can enhance scalability of a device.

Furthermore, each of the plurality of pixels further includes a microlens provided on a main surface of the planarizing layer facing the light source.

With the above-stated construction, light focus efficiency can be improved and the solid-state image sensor having a high sensitivity can be realized.

The above problem is also solved by a solid-state image sensor having a plurality of pixels, wherein each of the plurality of pixels includes a filter membrane for transmitting light of a predetermined color, and a photoelectric conversion unit for converting the light transmitted through the filter membrane into a charge; the filter membrane is a single layer film composed of an inorganic material; and an optical thickness of the single layer film is set according to which of a plurality of colors is to be transmitted in a range of 150 nm to 400 nm inclusive.

With the above-stated construction, the filter membrane is composed of an inorganic material. Therefore, the filter membrane has more excellent light resistance than a conventional filter membrane. Also, an optical thickness of the single layer film is in a range of 150 nm to 400 nm inclusive. This enables a local maximal value of a light transmittance to appear at a wavelength of a color to be transmitted in a transmission spectrum of the filter membrane. Therefore, an optical thickness of the filter membrane can be thinned to a thickness equivalent to one half of a wavelength of each color without degrading a color separation characteristic of the filter membrane.

The above problem is also solved by a solid-state image sensor having a plurality of pixels, wherein each of the plurality of pixels includes a filter membrane for transmitting light of a predetermined color, and a photoelectric conversion unit for converting the light transmitted through the filter membrane into a charge the shorter a wave length of the predetermined color is, the smaller a light absorption coefficient in an optical wavelength region of an inorganic material composing the filter membrane is.

With the above-stated construction, the filter membrane is composed of an inorganic material. Therefore, the filter membrane has more excellent light resistance than a conventional filter membrane.

Also, the light absorption coefficient of the filter membrane is different by varying a composition of the inorganic material.

With the above-stated construction, since a material of an inorganic material according to colors is same, there is no need to manage a material according to colors in a manufacturing process of the filter membrane. Also, the filter membrane can be manufactured more easily than a conventional filter membrane that needs an additional process for dispersing a pigment according to colors in a transparent resin because a composition of the filter membrane is varied according to colors in a forming step thereof. Therefore, the manufacturing cost of the filter membrane can be reduced.

Moreover, an optical thickness of the filter membrane is smaller than a thickness equivalent to one half of a wavelength of the predetermined color, by a thickness corresponding to an amount of the light of the predetermined color absorbed by the inorganic material.

With the above-stated construction, an optical thickness of the filter membrane is smaller than a thickness equivalent to one half of a wavelength of the predetermined color, by a thickness corresponding to an amount of the light of the predetermined color absorbed by the inorganic material. This enables a local maximal value of a light transmittance to appear at a wavelength of the predetermined color in a transmission spectrum of the filter membrane. Therefore, an optical thickness of the filter membrane can be thinned to a thickness equivalent to one half of a wavelength of each color without degrading a color separation characteristic of the filter membrane.

## Brief Description of the Drawings

FIG. 1 shows a construction of a camera system.
FIG. 2 is a cross section of a substrate showing a construction of pixels (1a, 1b, and 1c) of a first embodiment.
FIG. 3 shows transmission spectra of filter membranes 21a, 21b, and 21c of the first embodiment.
FIG. 4 shows an internal construction of a signal processing circuit.
FIG. 5 is a determinant used for the signal processing circuit.
FIG. 6 shows color signal spectra generated by processing a digital signal.
FIG. 7 is a cross section of a substrate showing a construction of pixels (1a, 1b, and 1c) of a second embodiment.
FIG. 8 shows transmission spectra of filter membranes 21a, 21b, and 21c of the second embodiment.
FIG. 9 is a cross section of a substrate showing a construction of pixels (1a, 1b, and 1c) of a third embodiment.
FIG. 10 is a cross section of a process showing a manufacturing method of a filter membrane 21 of a fourth embodiment.
FIG. 11 is a cross section of the filter membrane 21 manufactured by the manufacturing method of the fourth embodiment.
FIG. 12 is a cross section of a process showing a manufacturing method of a filter membrane 21 of a fifth embodiment.
FIG. 13 is a cross section of the filter membrane 21 manufactured by the manufacturing method of the fifth embodiment.
FIG. 14 is a cross section of a substrate showing a construction of pixels (1a, 1b, and 1c) of the fifth embodiment.
FIG. 15 shows transmission spectra of filter membranes 51a, 51b, and 51c of a sixth embodiment.
FIG. 16 is a cross section of a substrate showing a construction of pixels (1a, 1b, and 1c) of a seventh embodiment.
FIG. 17 shows transmission spectra of filter membranes 61a, 61b, and 61c of the seventh embodiment.
FIG. 18 is a cross section of a substrate showing a construction of pixels (1a 1b, and 1c) of an eighth embodiment.
FIG. 19 shows transmission spectra of filter membranes 61a, 61b, and 61c of the eighth embodiment.
FIG. 20 is a cross section of a substrate showing a construction of pixels (1a, 1b, and 1c) of a ninth embodiment.

FIG. 21 shows transmission spectra of filter membranes 71a, 71b, and 71c of the ninth embodiment. FIG. 22 is a cross section of a process showing a manufacturing method of a filter membrane 61 of a tenth embodiment.

**Description of Reference Numerals**

| | |
|---|---|
| 1: | solid-state image sensor |
| 2: | drive circuit |
| 3: | vertical scanning circuit |
| 4: | horizontal scanning circuit |
| 5: | analog front end |
| 6: | signal processing circuit |
| 7: | working memory |
| 8: | recording memory |
| 9: | control unit |
| 11: | substrate |
| 12: | photoelectric conversion unit forming layer |
| 13: | insulating layer |
| 14: | light shielding film forming layer |
| 15: | filter forming layer |
| 16: | P-type well |
| 17: | photoelectric conversion unit |
| 19: | light shielding film |
| 20: | opening |
| 21, 51, 61, 71: | filter membrane |
| 22: | planarizing layer |
| 23: | microlens |
| 30: | antireflection film |

**Best Mode for Carrying out the Invention**

The following describes a solid-state image sensor according to embodiments of the present invention, with reference to the attached drawings. Note that the present invention is not limited to the following embodiments.

<First embodiment>

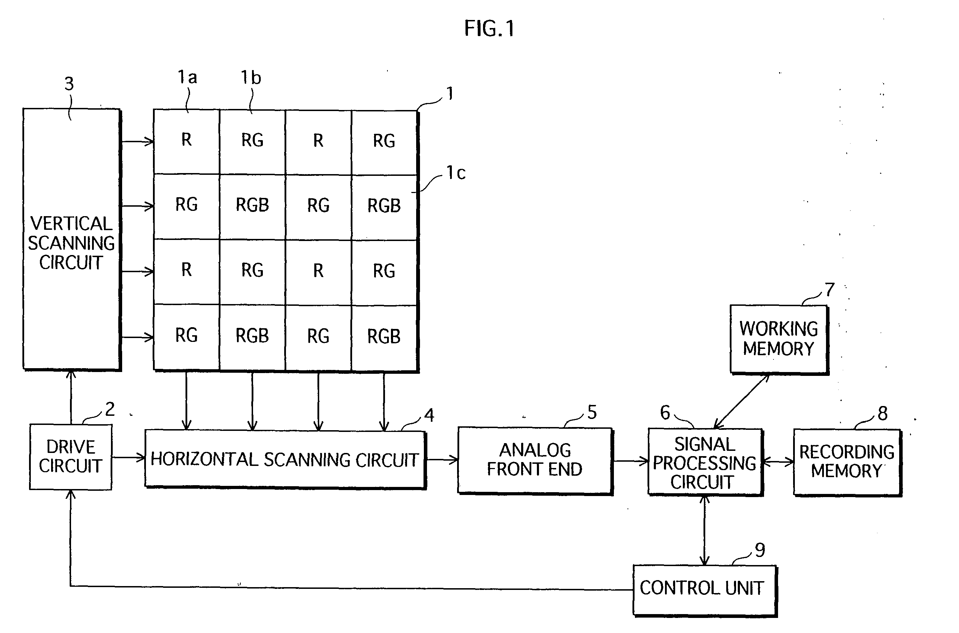

FIG. 1 shows a construction of a camera system of the present invention.
The camera system is mounted on a digital camera, a digital video camera, and the like to generate image data, and includes a solid-state image sensor 1, a drive circuit 2, a vertical scanning circuit 3, a horizontal scanning circuit 4, an analog front end 5, a signal processing circuit 6, a working memory 7, a recording memory 8, and a control unit 9.
The solid-state image sensor 1 is a MOS-type image sensor, and has a plurality of pixels (1a, 1b, 1c and the like). Each of the plurality of pixels in FIG. 1 describes "R", "RG", or "RGB". "R" transmits light in a red region in an optical wavelength region, and shows a pixel having a local maximal value in a light transmission spectrum in the red region. "RG" transmits light in red and green regions in an optical wavelength region, and shows a pixel having a local maximal value in a light transmission spectrum in the green region. "RGB" transmits light in red, green, and blue regions in an optical wavelength region, and shows a pixel having a local maximal value in a light transmission spectrum in the blue region.

For example, a pixel 1a has a sensitivity mainly to the red region, and outputs a signal corresponding to the amount of received light. A pixel 1b has a sensitivity mainly to the green and red regions, and outputs a signal corresponding to the amount of received light. A pixel 1c has a sensitivity mainly to the blue, green, and red regions, and outputs a signal corresponding to the amount of received light.
As shown in FIG. 1, the arrangement of color filters conforms to the Bayer arrangement.

Note that in this description, a wavelength in the blue region is in a range of 400 nm to 490 nm inclusive, a wavelength in the green region is in a range of 490 nm to 580 nm inclusive, and a wavelength in the red region is in a range of 580 nm to 700 nm inclusive. Also, a wavelength region that is equal to or less than 400 nm is an ultraviolet region, and a wavelength region that is equal to or larger than 700 nm is an infrared region.
The drive circuit 2 drives the vertical scanning circuit 3 and the horizontal scanning circuit 4 based on a trigger signal from the control unit 9.

The vertical scanning circuit 3 activates each of the plurality of pixels of the solid-state image sensor 1 line by line in sequence by a driving instruction from the drive circuit 2, and simultaneously transfers the activated pixel signals of one line to the horizontal scanning circuit 4.
The horizontal scanning circuit 4 operates in synchronization with the vertical scanning circuit 3 by a driving instruction from the drive circuit 2, and outputs the transferred pixel signals of one line to the analog front end 5 column by column in sequence. The signal of each of the plurality of pixels arranged in a matrix in a plane is transformed into voltage by the drive circuit 2, the vertical scanning circuit 3, and the horizontal scanning circuit 4 to serially output to the analog front end 5.

The analog front end 5 samples and amplifies the voltage signal, and trans forms the voltage signal from an analog signal to a digital signal to output to the signal processing circuit 6.
The signal processing circuit 6 is a DSP (Digital Signal Processor), and transforms the digital signal from the analog front end 5 into a red signal, a green signal, and a blue signal to generate image data.

Specifically, the working memory 7 is a SDRAM that is used when the signal processing circuit 6 transforms a digital signal corresponding to each of the plurality of pixels into a color signal of each of the colors.
The recording memory 8 is a SDRAM that records the image data generated by the signal processing circuit 6. The control unit 9 controls the drive circuit 2 and the signal processing circuit 6. For example, when a user pushes a shutter button, the control unit 9 outputs a trigger signal to the drive circuit 2.

The following describes a construction of each of the plurality of pixels (1a, 1b, and 1c) of the solid-state image sensor i.

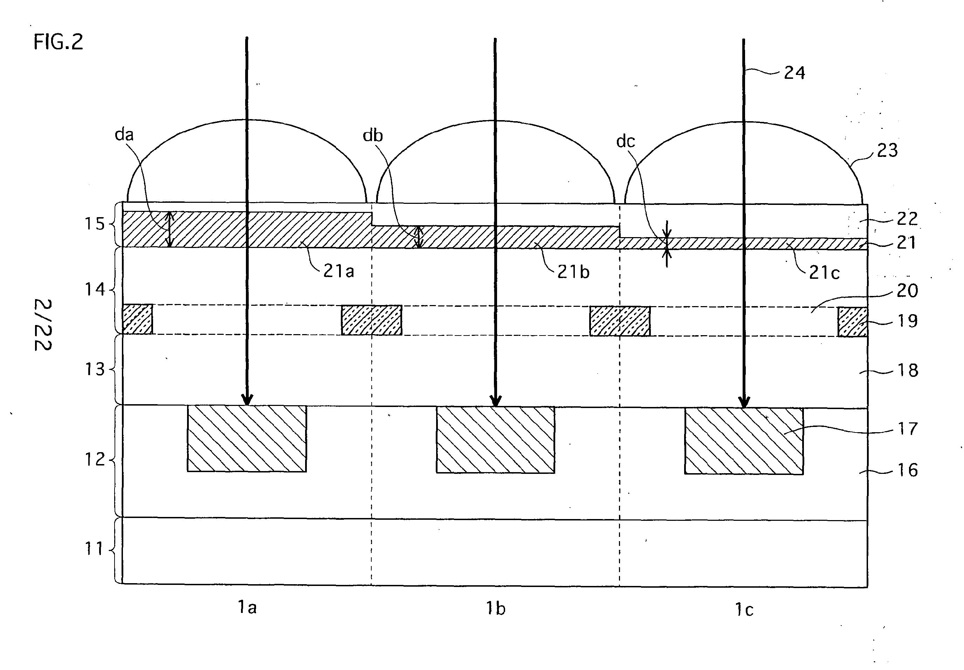

FIG. 2 is a cross section of a substrate showing a construction of pixels (1a, 1b, and 1c) of the first embodiment. Each of the pixels is composed of each of the following layers based on a substrate 11 that is composed of silicon to which a N-type impurity is added.

A photoelectric conversion unit forming layer 12 includes a P-type well 16 and a photoelectric conversion unit 17. The P-type well 16 is formed by an ion implantation of a P-type impurity in the substrate 11. The photoelectric conversion unit 17 as a N-type region is formed by an ion implantation of a N-type impurity in the P-type well 16.

An insulating layer 13 is composed of silicon dioxide 18, and provided for insulating the photoelectric conversion unit forming layer 12 from a light shielding film forming layer 14, and planarizing the image sensor.

The light shielding film forming layer 14 includes a wiring from the vertical scanning circuit 3 and a wiring that transfers a signal charge to the horizontal scanning circuit 4, and the wirings are formed by a CVD method. A light shielding film 19 is also formed by the CVD method, and the silicon dioxide 18 is formed in order to planarize the image sensor.

A filter forming layer 15 includes each of filter membranes (21a, 21b, and 21c) and a planarizing layer 22 composed of silicon dioxide. The larger a physical thickness of each of the filter membranes (21a, 21b, and 21c) (da, db, and dc) is, the smaller a thickness of the planarizing layer 22 is.

Incident light 24 is entered from an upper part of the pixel, concentrated by a microlens 23, and reached to the photoelectric conversion unit 17 through each of the filter membranes (21a, 21b, and 21c) and an opening 20 that is formed in the light shielding film 19.

In the incident light 24 entered into the pixel 1a, light whose wavelength region has a local maximal value in a red region is reached to the photoelectric conversion unit 17 through the filter membrane 21a. In the incident light 24 entered into the pixel 1b, light whose wavelength region has a local maximal value in a green region is reached to the photoelectric conversion unit 17. In the incident light 24 entered into the pixel 1c, light whose wavelength region has a local maximal value in a blue region is reached to the photoelectric conversion unit 17.

The incident light 24 transmitted through each of the filter membranes (21a, 21b, and 21c) is passed through the opening 20 that is formed in the light shielding film 19.

The light shielding film 19 is formed by the CVD method and the like. In order to prevent scattered light from an adjacent pixel from reaching the photoelectric conversion unit 17, a portion right above the photoelectric conversion unit 17 is opened by providing the opening 20, and the light shielding film 19 shields light from a rest portion other than the opening 20. With this construction, only incident light that is near-vertical to the substrate 11 can be reached to the photoelectric conversion unit 17, and oblique light is shielded.

The photoelectric conversion unit 17 forms a photodiode by a PN junction with the P-type well 16, and generates a signal charge according to brightness of light that is reached to the photoelectric conversion unit 17 through each of the filter membranes (21a, 21b, and 21c) and the opening 20. A structure of the photoelectric conversion is as follows.

In the photoelectric conversion unit 17, a depletion region is formed in which an electron as a carrier is combined with an electron hole as a P-type well carrier and disappears. This relatively increases an electric potential of the photoelectric conversion unit 17, and relatively decreases an electric potential of the P-type well 16. Therefore, an internal electric field occurs in the depletion region.

In this state, when the incident light 24 is reached to the photoelectric conversion unit 17, an electron-hole pair is generated by the photoelectric conversion, and the electron and the electron hole drift in an opposite direction by the internal electric field. In other words, the electron drifts toward a center of the photoelectric conversion unit 17, and the electron hole drifts toward the P-type well. As a result, the electron is accumulated in the photoelectric conversion unit 17, and the accumulated electron becomes a signal charge of each of the pixels.

Then, the pixel 1a generates a signal charge according to brightness of light in the incident light 24 whose wavelength region has a local maximal value in a red region. The pixel 1b generates a signal charge according to brightness of light whose wavelength region has a local maximal value in a green region. The pixel 1c generates a signal charge according to brightness of light whose wavelength region has a local maximal value in a blue region.

In the first embodiment, each of filter membranes (21a, 21b, and 21c) is a single layer film composed of amorphous silicon. An optical thickness of each of the filter membranes (21a, 21b, and 21c) is smaller than a thickness equivalent to one half of a wavelength of a color to be transmitted, by a thickness corresponding to an amount of light of the color to be transmitted absorbed by amorphous silicon. The color to be transmitted is each of the colors red (R), green (G), and blue (B).

Only considering an interference effect of light in a filter membrane, a local maximal value of a transmittance appears at a wavelength $\lambda$ corresponding to a thickness that is twice as thick as an optical thickness nd of the filter membrane in a light transmission spectrum. In other words, if the optical thickness nd of the filter membrane is equal to one half of a wavelength of a color to be transmitted, a local maximal value of a transmittance appears at the wavelength according to a relational expression nd=λ/2.

Because light is actually absorbed in a filter membrane, not only the interference effect of light but also an absorption effect are required to be considered. With regard to an absorption coefficient of a general inorganic material, the shorter a light wavelength is, the larger the absorption coefficient is. In other words, as the lightwavelengthbecomes shorter, a transmittance decreases because light is absorbed. As a result, a wavelength indicating a local maximal value of a light transmittance shifts to a long-wavelength side. Therefore, by adjusting an optical thickness of each of the filter membranes to be smaller than a thickness equivalent to one half of a wavelength of a color to be transmitted, by a thickness corresponding to an amount of light of the color to be transmitted absorbed by amorphous silicon, it is possible that a local maximal value of a light transmittance appears at a wavelength of a color to be transmitted.

Here, a wavelength λ of red is 650 nm, a wavelength λ of green is 560 nm, and a wavelength λ of blue is 490 nm. Therefore, one half of the wavelength λ of red is 325 nm, one half of the wavelength λ of green is 280 nm, and one half of the wavelength λ of blue is 245 nm. Since an optical thickness is smaller than a thickness equivalent to one half of a wavelength of a color to be transmitted, by a thickness corresponding to an amount of light of the color to be transmitted absorbed by amorphous silicon, an optical thickness of the red filter membrane is 315 nm, an optical thickness of the green filter membrane is 260 nm, and an optical thickness of the blue filter membrane is 200 nm. A light absorbed amount is obtained by an absorption coefficient of amorphous silicon and an optical thickness of a filter membrane.

A refractive index of amorphous silicon at a wavelength of 650 nm is 4.5. A refractive index of amorphous silicon at a wavelength of 560 nm is 4.75. A refractive index of amorphous silicon at a wavelength of 490 nm is 5.0. Therefore, the physical thicknesses (da, db, and dc) of each of the filter membranes (21a, 21b, and 21c) are da=70 nm, db=55nm, and dc=40 nm respectively.

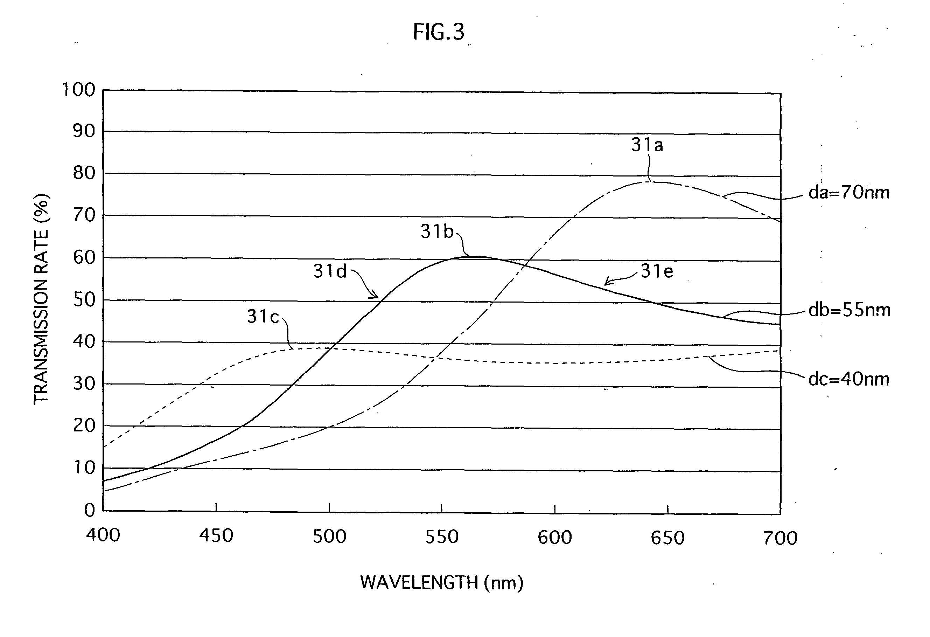

FIG. 3 shows transmission spectra of the filter membranes 21a, 21b, and 21c of the first embodiment.

A curved line 31a shows a transmission spectrum of the filter membrane 21a. A curved line 31b shows a transmission spectrum of the filter-membrane 21b. A curved line 31c shows a transmission spectrum of the filter membrane 21c.

The filter membrane 21a has a local maximal value of a light transmittance at the red wavelength of 650nm. The filter membrane 21b has a local maximal value of a light transmittance at the green wavelength of 560nm. The filter membrane 21c has a local maximal value of a light transmittance at the blue wavelength of 490nm. The larger an optical thickness of a filter membrane is, the longer a wavelength at which a light transmittance is a local maximal value is. For this reason, it can be expected that a local maximal value appears in a light transmission spectrum because of an interference effect of light.

A local maximal value of a transmittance of the filter membrane 21a is 78%. A local maximal value of a transmittance of the filter membrane 21b is 61%. A local maximal value of a transmittance of the filter membrane 21c is 38%. It can be expected that the shorter a color wavelength is, the smaller the local maximal value is because the shorter the color wavelength is, the larger an absorption coefficient of amorphous silicon is.

Also, when focusing attention on a transmission spectrum of one filter membrane (for example, the filter membrane 21b: the curved line 31b), a slope of a short-wavelength side curved line (31d) of the wavelength at which a light transmittance is a local maximal value (560 nm) is larger than a slope of a long-wavelength side curved line (31e). Because the shorter a light wavelength is, the larger an absorption coefficient of amorphous silicon is, a transmittance of the short-wavelength side decreases. This absorption effect improves a color separation characteristic because light of the short-wavelength side is easily cut.

As shown in FIG. 3, any filter membrane transmits light in an entire visible wavelength region (400 nm to 700 nm). As a result, for example, each of components of color signals (R, G, and B) is included in a signal obtained from the pixel 1a having the filter membrane 21a based on a ratio of the transmission spectrum 31a. Also, same applies to the pixels 1b and 1c.

Therefore, in order to derive the color signals (R, G, and B) for generating image data, a process has to be performed on digital signals (Sa, Sb, and Sc) obtained from the pixels 1a, 1b, and 1c. The following describes a method thereof.

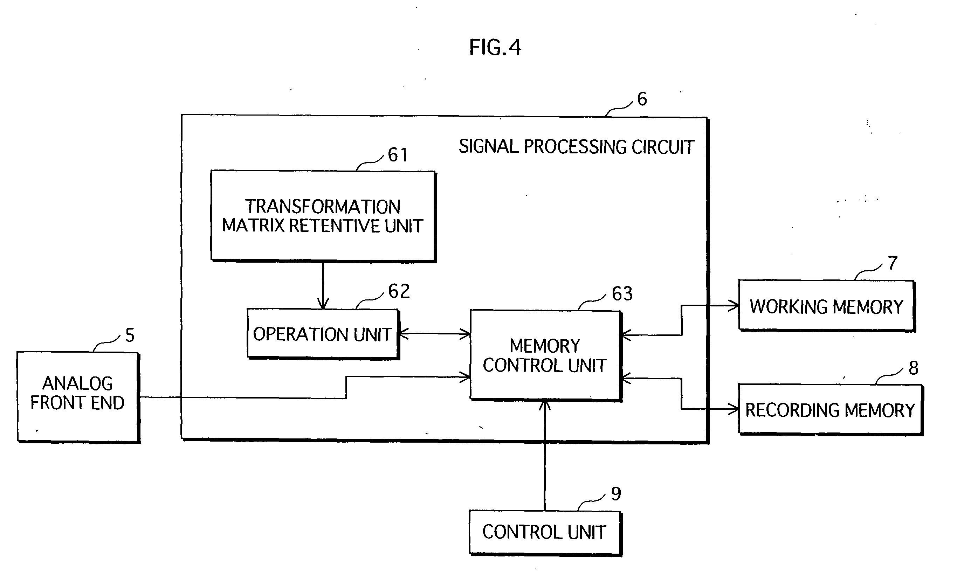

FIG. 4 shows an internal construction of a signal processing circuit.

A signal processing circuit 6 includes a transformation matrix retentive unit 61, an operation unit 62, and a memory control unit 63.

The transformation matrix retentive unit 61 retains a transformation matrix that transforms the digital signals (Sa, Sb, and Sc) generated in the analog front end 5 into the color signals (R, G, and B).

There is a relation between the digital signals (Sa, Sb, and Sc) and the color signals (R, G, and B) as shown in FIG. 5A.

Here, each of elements in the matrix $W_{11}$ to $W_{33}$ is a weighting factor based on the transmission spectrum of each of the filter membranes 21a, 21b, and 21c.

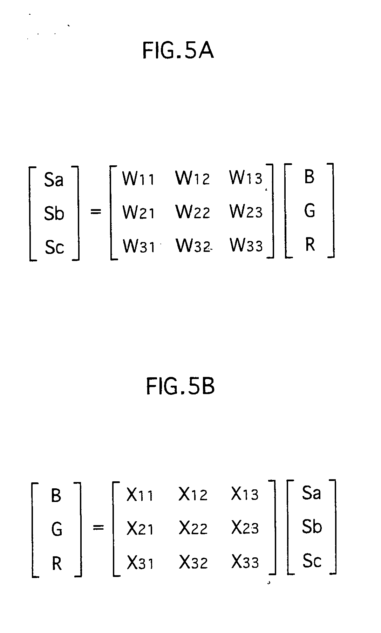

Each of the elements in the matrix $W_{11}$ to $W_{33}$ is inversely transformed into the transformation matrix. There is a relation between the digital signals (Sa, Sb, and Sc) and the color signals (R, G, and B) as shown in FIG. 5B. Here, each of elements in the transformation matrix $X_{11}$ to $X_{33}$ is obtained by inversely transforming the matrix in FIG. 5A.

The memory control unit 63 controls the access to the working memory 7 and the recording memory 8. The memory control unit 63 receives the digital signal from the analog front end 5, and stores the digital signal in the working memory 7 once. When image data corresponding to one frame is accumulated in the working memory 7, the memory control unit 63 obtains a portion of the image data from the working memory 7, and inputs the portion of the image data to the operation unit 62.

The operation unit 62 obtains the color signals (R, G, and B) by multiplying the digital signals (Sa, Sb, and Sc) by the transformation matrix retained in the transformation matrix retentive unit 61.

The memory control.unit 63 stores the color signals (R, G, and B) obtained by the operation unit 62 in the recording memory 8. As a result, the image data corresponding to one frame is recorded in the recording memory 8.

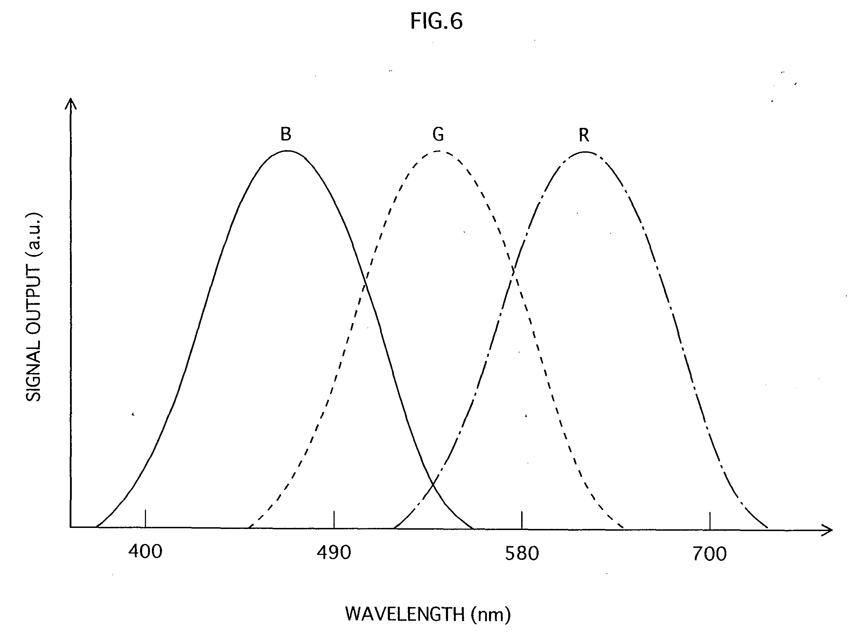

FIG. 6 shows color signal spectra generated by processing a digital signal.

Each of parameters is determined in order to get close to the ideal spectroscopy of a NTSC.

As described above, in the first embodiment, an optical thickness of each of the filter membranes is properly adjusted according to a color to be transmitted. With this construction, the transmission spectra shown in FIG. 3 can be obtained and each of the filter membranes functions as a color filter.

Since each of the filter membranes (21a, 21b, and 21c) is composed of a same material (amorphous silicon), there is no need to manage a material according to colors in a manufacturing process of the filter membrane. Therefore, the manufacturing cost of the filter membrane can be reduced.

Each of the filter membranes (21a, 21b, and 21c) can be manufactured by a semiconductor process. If the semiconductor process can be used, there is no need to provide a manufacturing line of a color filter exclusively for an organic material. Therefore, the manufacturing cost of a filter membrane can be reduced.

In recent years, there is a request for thinning a color filter to prevent a color mixture among pixels. The color mixture is caused when oblique incident light entering in a color filter of a pixel is reached to a photoelectric conversion unit of an adjacent pixel to the pixel. By thinning a filter membrane, a color mixture can be prevented. In the first embodiment, a physical thickness of each of the filter membranes (21a, 21b, and 21c) is extremely thin and is 70 nm at a maximum. Therefore, a color mixture is effectively prevented.

A refractive index of amorphous silicon is about 5 that is larger than a normal insulating film and the like (for example, a refractive index of silicon dioxide is 1.46). Therefore, even if oblique incident light enters in a filter membrane, a refracting angle is small and a color mixture among pixels can be prevented.

Also, with regard to amorphous silicon, a film can be formed at a low temperature. Therefore, a filter membrane can be formed after a light shielding film such as low-melting aluminum is formed. As a result, a manufacturing procedure can be changed freely. Moreover, if amorphous silicon is used, a stress on a photoelectric conversion unit can be reduced. Therefore, the damage to the photoelectric conversion unit can be reduced.

With regard to a general interference filter, if a light incident angle changes, an interfering wavelength shifts to a short-wavelength side because a light path length becomes shorter. Therefore, it has been a problem to use the general interference filter for a solid-state image sensor because each of vertical incident light and oblique incident light has a different color separation characteristic. When light enters at an angle of 30 degrees, a refractive angle of amorphous silicon is 5.7 degrees because a refractive index of amorphous silicon is about 5 and large. Therefore, there is little influence by oblique incident light. With regard to a general interference filter, the larger a film thickness is, the greater an influence by oblique incident light is. However, a film thickness of each of the filter membranes of the first embodiment is not larger than 100 nm. As a result, there is little influence by oblique incident light.

Note that amorphous silicon used for each of the filter membranes (21a, 21b, and 21c) is an absorbent material. In this description, the absorbent material is defined as a material having a wavelength whose extinction coefficient is equal to or larger than 0.1 in a range of a wavelength of 400 nm to 700 nm inclusive. There is a relation among an absorption coefficient $\alpha$, an extinction coefficient k, and a wavelength $\lambda$ that $k = \alpha x \lambda / 4\pi$.

<Second embodiment>

In a second embodiment, an example that an antireflection film 30 is formed on a main surface of each of the filter membranes (21a, 21b, and 21c) facing a light source is described. Since other constructions except for the antireflection film 30 are same as the first embodiment, an explanation thereof is omitted.

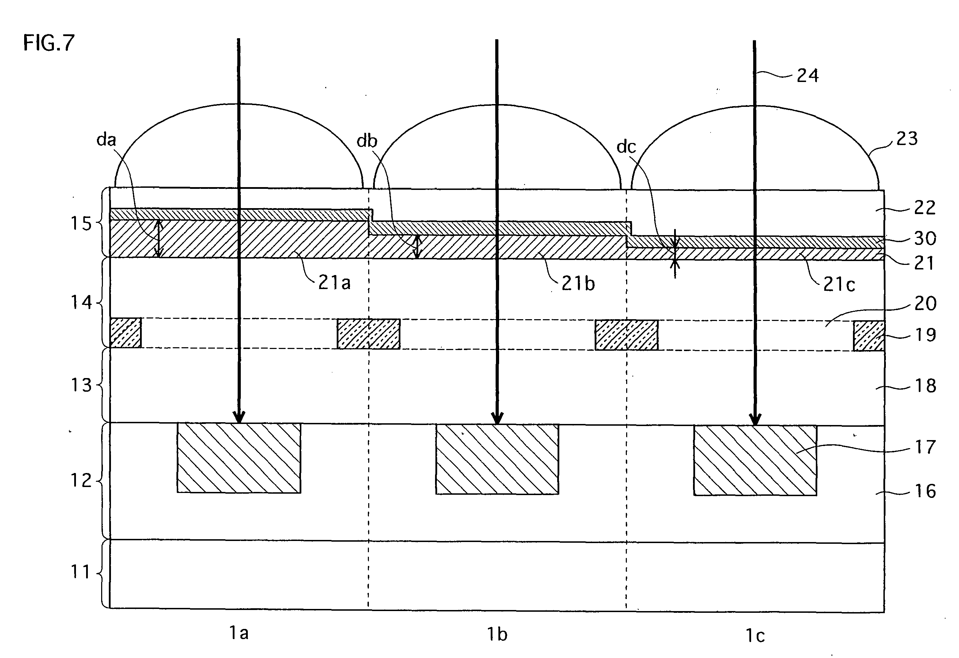

FIG. 7 is a cross section of a substrate showing a construction of pixels (1a, 1b, and 1c) of the second embodiment.

The antireflection film 30 is formed on the main surface of each of the filter membranes (21a, 21b, and 21c) facing the light source. The antireflection film 30 is composed of silicon nitride and a physical thickness thereof is 50 nm. Note that physical thicknesses of each of the filter membranes 21a, 21b, and 21c are same as the first embodiment, and are 70 nm, 55 nm, and 40 nm respectively.

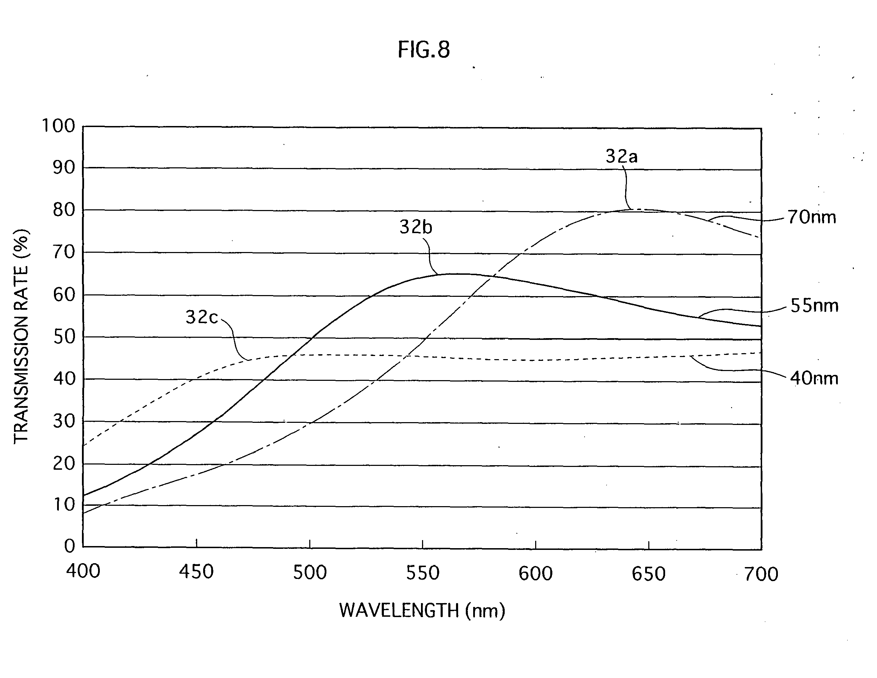

FIG. 8 shows transmission spectra of the filter membranes 21a, 21b, and 21c of the second embodiment.

A curved line 32a shows a transmission spectrum of the filter membrane 21a. A curved line 32b shows a transmission spectrum of the filter membrane 21b. A curved line 32c shows a transmission spectrum of the filter membrane 21c.

The filter membrane 21a has a local maximal value of a light transmittance at a red wavelength of 650nm. The filter membrane 21b has a local maximal value of a light transmittance at a green wavelength of 560nm. The filter membrane 21c has a local maximal value of a light transmittance at a blue wavelength of 490nm.

Compared the first embodiment with the second embodiment regarding a transmission spectrum of a same filter membrane (for example, the filter membrane 21b: the curved lines 31b and 32b), a local maximal value (65%) of a transmittance of the second embodiment is larger than the local maximal value (61%) of a transmittance of the first embodiment. This is because a light reflectance decreases by providing the antireflection film 30.

The following describes a material and a refractive index of each part in which the incident light 24 enters. Note that the refractive index indicates a value when a wavelength of the incident light is 560 nm.

Opening 20: silicon dioxide, a refractive index: 1.46

Filter membrane 21: amorphous silicon, a refractive index: 4.77

Insulating layer 13: silicon dioxide, a refractive index: 1.46

Photoelectric conversion unit 17: N-type silicon, a refractive index: 4

The incident light 24 is concentrated by the microlens 23, and reached to the photoelectric conversion unit 17 through the opening 20 and each of the filter membranes (21a, 21b, and 21c). Generally, when light enters in one medium to another medium, a reflectance is determined by a ratio of refractive indexes of the two media. The following describes a reflectance R when light enters from a medium having a refractive index n1 to a medium having a refractive index n2.

$$R=((n1-n2)/(n1+n2))^2$$

When light enters from silicon dioxide (a refractive index: 1.46) that is generally used as a planarizing layer to amorphous silicon (a refractive index: 4.77), a reflectance is 28%. On the other hand, when light enters from silicon nitride (a refractive index: 2.00) to amorphous silicon (a refractive index: 4.77), a reflectance is 17%. In other words, since a reflectance decreases by 10%, a transmittance increases. As a result, a light amount that enters in the photoelectric conversion unit 17 in each of the pixels increases, and a sensitivity of the solid-state image sensor 1 is improved. This is effective as a method for preventing a sensitivity from decreasing because of the miniaturization of pixels.

By forming silicon nitride on amorphous silicon as each of the filter membranes (21a, 21b, and 21c), there are effects of not only improving a sensitivity but also increasing the reliability and the humidity resistance of the solid-state image sensor 1.

<Third embodiment>

In a third embodiment, an example that each of the filter membranes (21a, 21b, and 21c) is formed between the photoelectric conversion unit 17 and the light shielding film 19 is described. Since other constructions are same as the first embodiment, an explanation thereof is omitted.

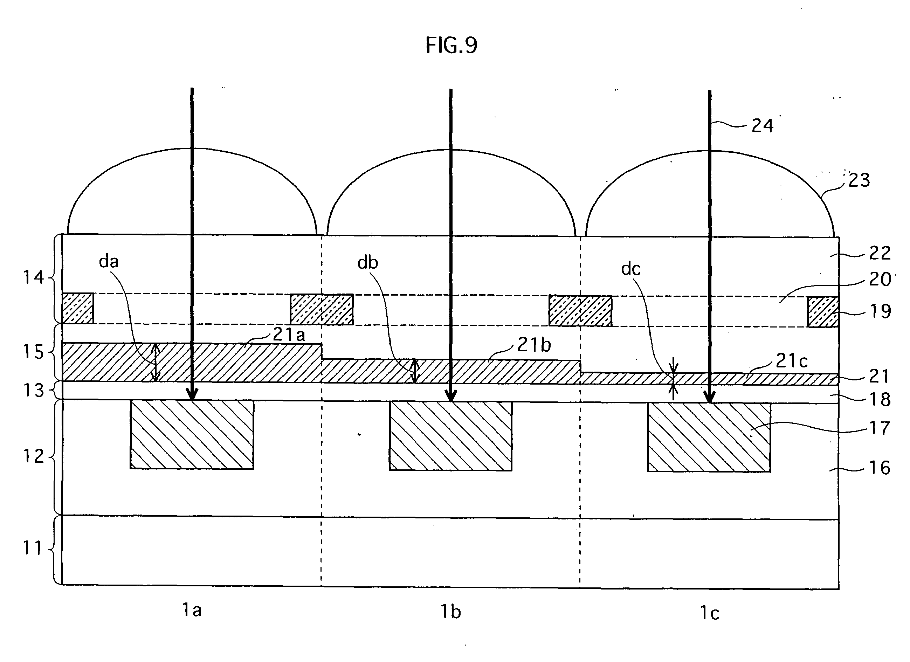

FIG. 9 is a cross section of a substrate showing a construction of pixels (1a, 1b, and 1c) of the third embodiment.

Each of the filter membranes (21a, 21b, and 21c) is formed between the photoelectric conversion unit 17 and the light shielding film 19. Note that physical thicknesses of each of the filter membranes (21a, 21b, and 21c) are same as the first embodiment, and are 70 nm, 55 nm, and 40 nm respectively.

The filter forming layer 15 includes each of the filter membranes (21a, 21b, and 21c), and can be formed by a normal semiconductor process. Therefore, the filter forming layer 15 can be formed between the photoelectric conversion unit forming layer 12 and the light shielding film forming layer 14.

Moreover, because the filter forming layer 15 can be formed before a wiring process, polysilicon that is required to be processed at a high temperature can be used.

Since each of the filter membranes (21a, 21b, and 21c) is composed of amorphous silicon, there is the possibility that a signal charge generated in the photoelectric conversion unit 17 leaks into each of the filter membranes (21a, 21b, and 21c) unless the filter membrane 21 is insulated from the photoelectric conversion unit forming layer 12. Therefore, the insulating layer 13 is provided between each of the filter membranes (21a, 21b, and 21c) and the photoelectric conversion unit forming layer 12.

As described above, in addition to the effect of the pixels of the first embodiment, in the pixels of the third embodiment, a light interference between the photoelectric conversion unit 17 and each of the filter membranes (21a, 21b, and 21c) can be prevented because each of the filter membranes (21a, 21b, and 21c) is formed between the photoelectric conversion unit 17 and the light shielding film 19 . This improves a sensitivity of the solid-state image sensor 1.

Furthermore, the above-mentioned construction is effective as a method for preventing a color mixture because of the miniaturization of pixels.

<Fourth embodiment>

In a fourth embodiment, a manufacturing method of each of the filter membranes (21a, 21b, and 21c) will be described.

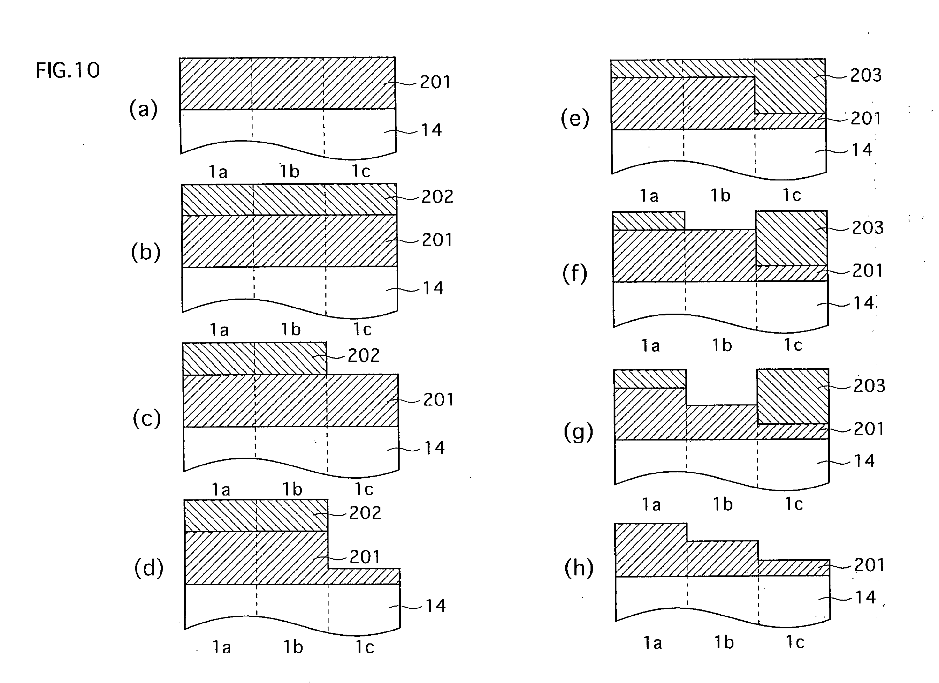

FIG. 10 is a cross section of a process showing a manufacturing method of each of the filter membranes (21a, 21b, and 21c) of the fourth embodiment.

FIG. 10 (a) shows a pixel after a film formation process.

In the film formation process, an amorphous silicon film 201 is formed in a whole upper part of a silicon oxide film of the light shielding film forming layer 14. With regard to amorphous silicon, when a film is formed, a PVD (Physical Vapor Deposition) method is used. A temperature of forming a film is set in a range of an ambient temperature to 400°C inclusive. When a thickness of the amorphous silicon film 201 is 70 nm, the film formation is stopped.

FIG. 10 (b) shows a pixel after a first application process.

In the first application process, photoresist (PR) 202 is applied on a whole upper part of the amorphous silicon film 201 that is formed in the film formation process.

FIG. 10 (c) shows a pixel after a first exposure and development process.

In the first exposure and development process, the photoresist (PR) 202 that is applied in the first application process is exposed with a certain pattern mask. Then, the exposed portion is removed and photoresist in a rest portion is cured. With this construction, only the photoresist 202 corresponding to the pixel 1c can be removed.

FIG. 10 (d) shows a pixel after a first etching process.

In the first etching process, dry etching is performed on the amorphous silicon film 201 after the first exposure and development process. As a result, the amorphous silicon film 201 of an area corresponding to the pixel 1c is etched. When a thickness of the amorphous silicon film 201 of the pixel 1c is 40 nm, the etching is stopped.

Note that a film thickness can be controlled by the dry etching with an accuracy of 3%.

FIG. 10 (e) shows a pixel after a second application process.

In the second application process, photoresist (PR) 203 is applied in a whole upper part of the amorphous silicon film 201 on which etching is performed.

FIG. 10 (f) shows a pixel after a second exposure and development process.

In the second exposure and development process, only the photoresist 202 corresponding to the pixel 1b can be removed.

FIG. 10 (g) shows a pixel after a second etching process.

In the second etching process, the amorphous silicon film 201 of an area corresponding to the pixel 1b is etched. When a thickness of the amorphous silicon film 201 of the pixel 1b is 55 nm, the etching is stopped.

FIG. 10 (h) shows a pixel after a photoresist removing process.

In the photoresist removing process, unnecessary photoresist 203 is removed.

As described above, since each of the filter membranes is composed of a same material (amorphous silicon), there is no need to manage a material according to colors in a manufacturing process of the filter membrane. Therefore, the manufacturing cost of the filter membrane can be reduced.

Each of the filter membranes is manufactured by a semiconductor process. Therefore, the manufacturing cost of the filter membrane can be reduced.

In the fourth embodiment, a temperature of forming a film is set in a range of an ambient temperature to 400°C inclusive. Also, with regard to amorphous silicon, a film canbeformedatalowtemperature. Therefore, afiltermembrane can be formed after a light shielding film such as low-melting aluminum is formed.

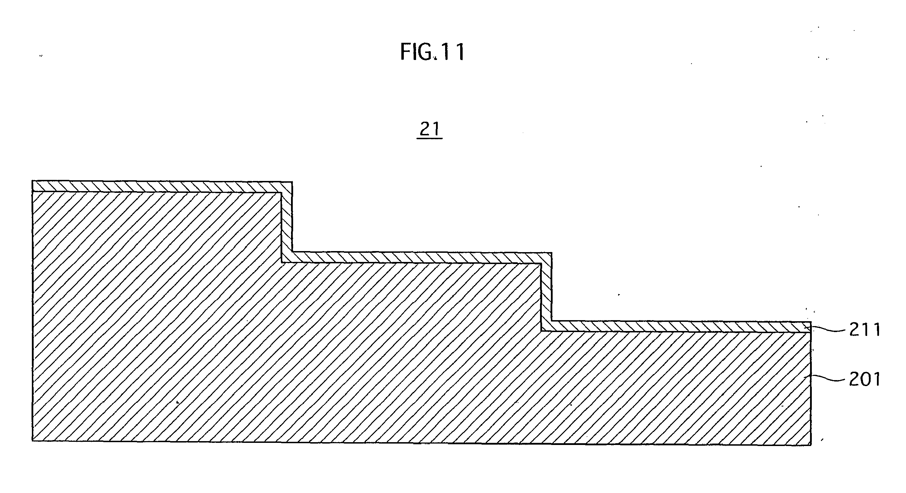

FIG. 11 is a cross section of each of the filter membranes (21a, 21b, and 21c) manufactured by the manufacturing method of the fourth embodiment .

By using the above-mentioned manufacturing method, there is the possibility that an oxide film 211 such as a natural oxide film having a thickness of equal to or less than 10 nm is formed on the amorphous silicon film 201. However, because a thickness of the oxide film 211 is equal to or less than 10 nm and extremely thin, the oxide film 211 has little influence on a transmission spectrum. By designing a device in view of a thickness of an oxide film, an excellent color separation characteristic can be obtained.

<Fifth embodiment>

In a fifth embodiment, a manufacturing method of each of the filter membranes (21a, 21b, and 21c) will be described.

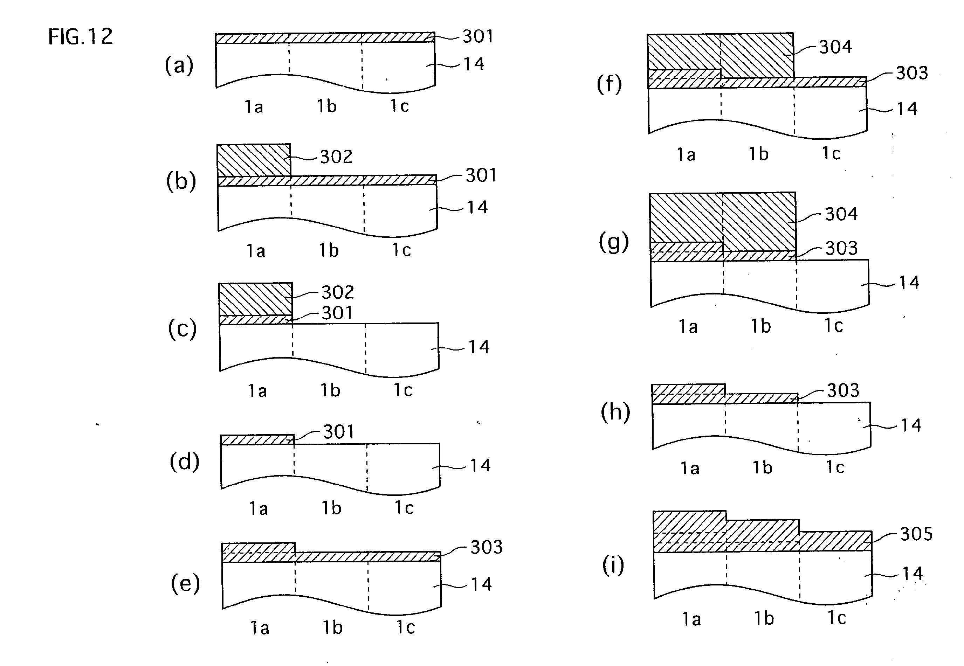

FIG. 12 is a cross section of a process showing a manufacturing method of each of the filter membranes (21a, 21b, and 21c) of the fifth embodiment.

FIG. 12 (a) shows a pixel after a first film formation process.

In the first film formationprocess, an amorphous silicon film 301 is formed in a whole upper part of an oxide silicon film of the light shielding film forming layer 14. With regard to amorphous silicon, when a film is formed, a PVD (Physical Vapor Deposition) method is used. A temperature of forming a film is set in a range of an ambient temperature to 400°C inclusive. When a thickness of the amorphous silicon film 301 is 15 nm, the film formation is stopped.

FIG. 12 (b) shows a pixel after a first exposure and development process.

In the first exposure and development process, photoresist (PR) 302 is applied on a whole upper part of the amorphous silicon film 301 that is formed in the first film formation process. Then, the photoresist 302 is exposed using a stepper to remove the photoresist 302 corresponding to the pixels 1b and 1c.

FIG. 12 (c) shows a pixel after a first etching process.

In the first etching process, dry etching is performed on the amorphous silicon film 301 after the first exposure and development process. As a result, the amorphous silicon film 301 of areas corresponding to the pixels 1b and 1c are removed.

FIG. 12 (d) shows a pixel after a first photoresist removing process.

In the first photoresist removing process, unnecessary photoresist 302 is removed. With this construction, the amorphous silicon film 301 having a thickness of 15 nm is formed in an area corresponding to the pixel 1a.

FIG. 12 (e) shows a pixel after a second film formation process.

In the second film formation process, an amorphous silicon film 3 03 is formed after the first photoresist removing process. When a thickness of the amorphous silicon film 303 is 15 nm, the film formation is stopped. As a result, a thickness of the amorphous silicon film 303 of each of the pixels 1a, 1b, and 1c is 30 nm, 15nm, and 15 nm respectively.

FIG. 12 (f) shows a pixel after a second exposure and development process.

In the second exposure and development process, photoresist (PR) 304 is applied on a whole upper part of the amorphous silicon film 303 that is formed in the second film formation process. Then, the photoresist 304 is exposed using a stepper to remove the photoresist 304 corresponding to the pixel 1c.

FIG. 12 (g) shows a pixel after a second etching process.

In the second etching process, the amorphous silicon film 303 of an area corresponding to the pixel 1c is removed.

FIG. 12 (h) shows a pixel after a second photoresist removing process.

In the second photoresist removing process, an amorphous silicon film having a thickness of 30 nm is formed in an area corresponding to the pixel 1a, and an amorphous silicon film having a thickness of 15 nm is formed in an area corresponding to the pixel 1b.

FIG. 12 (i) shows a pixel after a third film formation process.

In the third film formation process, an amorphous silicon film having a thickness of 40 nm is formed. Therefore, a thickness of each of the filter membranes (21a, 21b, and 21c) in each of the pixels 1a, 1b, and 1c is 70 nm, 55 nm, and 40 nm respectively.

In this state, the filter membranes (21a, 21b, and 21c) having three types of film thickness i.e. 70 nm, 55 nm, and 40 nm are formed. In other words, an amorphous silicon film having a thickness of 70 nm is formed in an area corresponding to the pixel 1a, an amorphous silicon film having a thickness of 55 nm is formed in an area corresponding to the pixel 1b, and an amorphous silicon film having a thickness of 40 nm is formed in an area corresponding to the pixel 1c.

As described above, since each of the filter membranes is composed of a same material (amorphous silicon), there is no need to manage a material according to colors in a manufacturing process of the filter membrane. Therefore, the manufacturing cost of the filter membrane can be reduced.

Each of the filter membranes is manufactured by a semiconductor process. Therefore, the manufacturing cost of the filter membrane can be reduced.

In the fifth embodiment, since a film thickness is controlled in the film formation process, an in-plane variation of the film thickness can be reduced compared to the method of controlling a film thickness by etching described in the fourth embodiment. As a result, the accuracy of.a film thickness can be increased.

In the fifth embodiment, a temperature of forming a film is set in a range of an ambient temperature to 400°C inclusive. Also, with regard to amorphous silicon, a film can be formed at a low temperature. Therefore, a filter membrane can be formed after a light shielding film such as low-melting aluminum is formed.

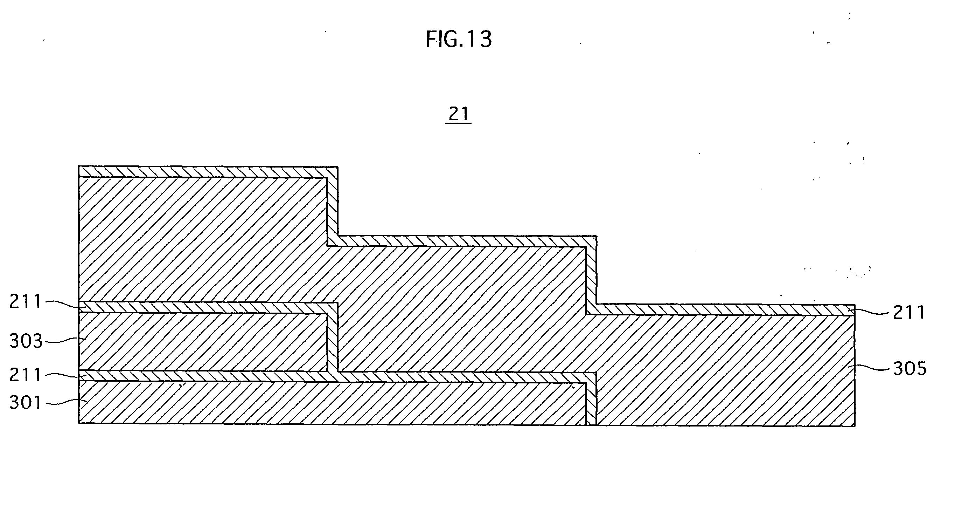

FIG. 13 is a cross section of each of the filter membranes (21a, 21b, and 21c) manufactured by the manufacturing method of the fifth embodiment.

By using the above-mentioned manufacturing method, there is the possibility that the oxide film 211 such as a natural oxide film is formed on the amorphous silicon films 301, 303, and 305. However, because a thickness of the oxide film 211 is equal to or less than 10 nm and extremely thin, the oxide film 211 has little influence on a transmission spectrum. By designing a device in view of a thickness of an oxide film, an excellent color separation characteristic can be obtained.

Note that in the fifth embodiment, the filter membranes are completed in a stage of FIG. 12 (i). However, the filter membranes may be completed in a stage of FIG. 12 (h).

In the filter membranes of FIG. 12 (h), three types of the film thicknesses are 30 nm; 15 nm, and 0 nm respectively. With this construction, there are different transmission bands of two colors (30 nm and 15 nm) in the pixels 1a and 1b, and a white color (0 nm) in the pixel 1c, and a color filter can be realized. With regard to the color filter, a thickness of amorphous silicon is about 30 nm and very thin, so there is less absorption of light and more transmission light amount. Therefore, a solid-state image sensor having a high sensitivity can be obtained.

On the other hand, in the construction of FIG. 12 (i), color separation is performed by an interference effect and an absorption effect. Compared to the construction of FIG. 12 (h), a transmitted light amount decreases because of the absorption by amorphous silicon. However, a solid-state image sensor having the color reproducibility can be obtained.

In both of FIG. 12 (h) and FIG. 12 (i), three different transmission bands can be obtained, and color separation can be realized. Since there is more transmitted light amount in FIG. 12 (h), a color filter shown in FIG. 12 (h) can be applied to a field that emphasizes the high sensitivity. Also, a color filter shown in FIG. 12 (i) can be applied to a field that emphasizes the color reproducibility.

<Sixth embodiment>

In a sixth embodiment, an example that each of filter membranes (51a, 51b, and 51c) is composed of titanium dioxide is described. Since other constructions are same as the first embodiment, an explanation thereof is omitted.

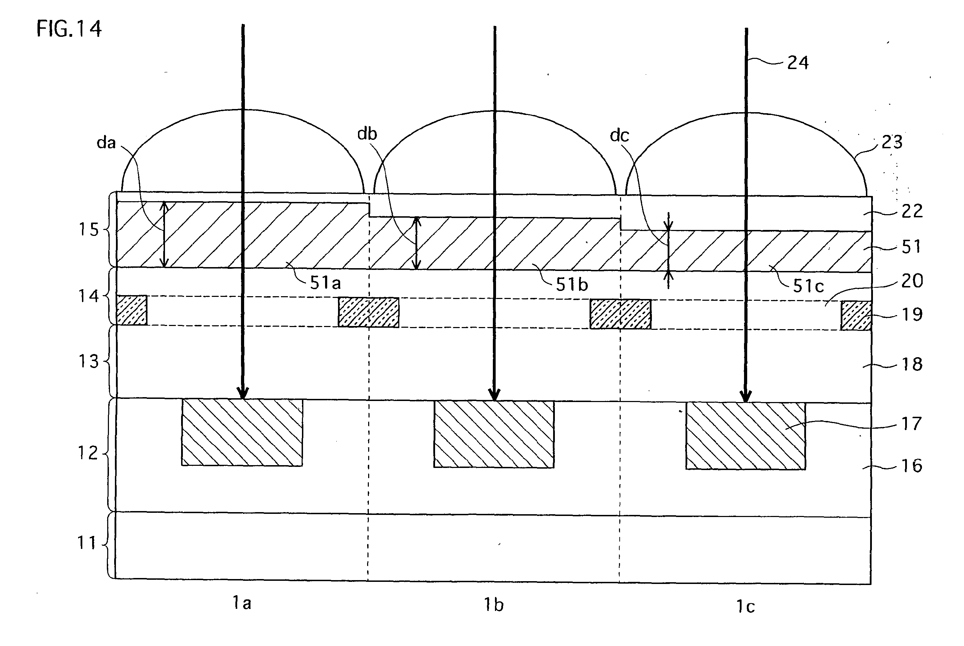

FIG. 14 is a cross section of a substrate showing a construction of pixels (1a, 1b, and 1c) of the sixth embodiment.

In the sixth embodiment; each of the filter membranes (51a, 51b, and 51c) is a single layer film composed of titanium dioxide. An optical thickness of each of the filter membranes is smaller than a thickness equivalent to one half of a wavelength of a color to be transmitted, by a thickness corresponding to an amount of light of the color to be transmitted absorbed by titanium dioxide.

As mentioned in the first embodiment, with this construction, it is possible that a local maximal value of a light transmittance appears at a wavelength of a color to be transmitted.

Titanium dioxide is different from amorphous silicon in that there is little absorption in an optical wavelength region (400 nm to 700 nm), and an extinction coefficient is nearly 0. Therefore, a correction according to a light absorption amount is nearly 0.

Here, a wavelength $\lambda$ of red is 630 nm, a wavelength $\lambda$ of green is 530 nm, and a wavelength $\lambda$ of blue is 470 nm. Therefore, one half of the wavelength $\lambda$ of red is 315 nm, one half of the wavelength $\lambda$ of green is 265 nm, and one half of the wavelength $\lambda$ of blue is 235 nm. Because a correction according to a light absorption amount is nearly 0, an optical thickness of the red filter membrane is 315 nm, an optical thickness of the green filter membrane is 265 nm, and an optical thickness of the blue filter membrane is 235 nm.

A refractive index of titanium dioxide at a wavelength of 630 nm is 2.46. A refractive index of amorphous silicon at a wavelength of 530 nm is 2.53. A refractive index of amorphous silicon at a wavelength of 470 nm is 2.60. Therefore, physical thicknesses (da, db, and dc) of each of the filter membrane (51a, 51b, and 51c) are da=125 nm, db=105nm, and dc=90 nm respectively.

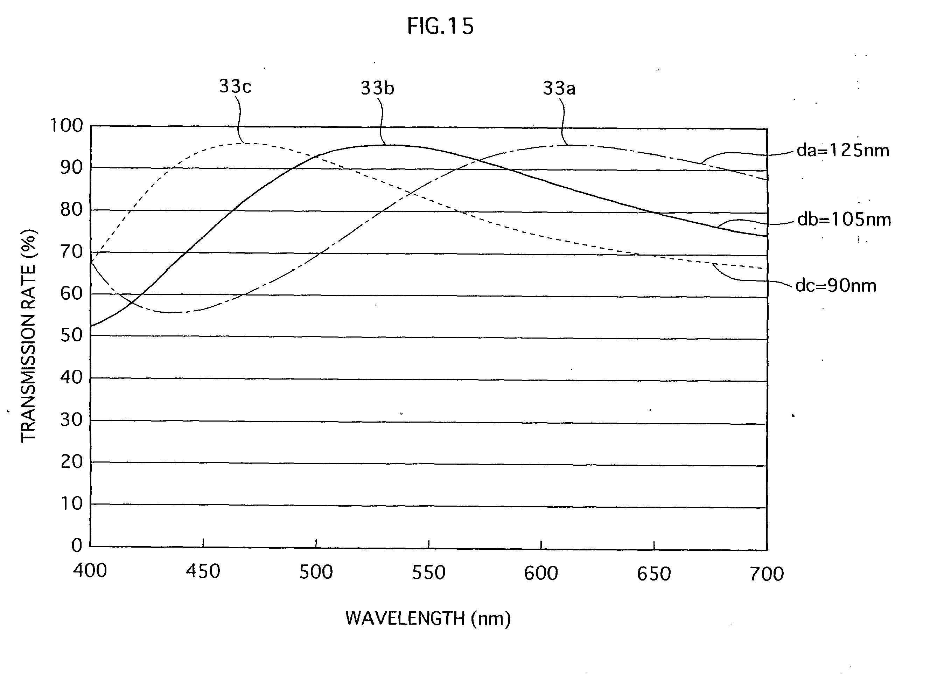

FIG. 15 shows transmission spectra of the filter membranes 51a, 51b, and 51c of the sixth embodiment.

A curved line 33a shows a transmission spectrum of the filter membrane 51a. A curved line 33b shows a transmission spectrum of the filter membrane 51b . A curved line 33c shows a transmission spectrum of the filter membrane 51c.

The filter membrane 51a has a local maximal value of a light transmittance at the red wavelength of 630nm. The filter membrane 51b has a local maximal value of a light transmittance at the green wavelength of 530nm. The filter membrane 51c has a local maximal value of a light transmittance at the blue wavelength of 470nm. The larger an optical thickness of a filter membrane is, the longer a wavelength at which a light transmittance is a local maximal value is. For this reason, it can be expected that a local maximal value appears in a light transmission spectrum because of an interference effect of light.

A local maximal value of a transmittance of the filter membrane 51a is 96%. A local maximal value of a transmittance of the filter membrane 51b is 96%. A local maximal value of a transmittance of the filter membrane 51c is 96%.

It can be expected that the local values are constant regardless of the color wavelength because an absorption coefficient of titanium dioxide is constant regardless of the wavelength.

Compared the first embodiment with the sixth embodiment regarding a transmission spectrum of the same filter membrane, the transmittance of the sixth embodiment is larger than the transmittance of the first embodiment. This is because an absorption coefficient of titanium dioxide is nearly 0 in an optical wavelength region.

Because there is little absorption in an optical wavelength region with regard to titanium dioxide, a high transmittance can be obtained on a short-wavelength side on which a transmittance in amorphous silicon decreases. As a result, a sensitivity of a solid-state image sensor can be improved.

As described above, in the sixth embodiment, each of the filter membrane (51a, 51b, and 51c) is composed of titanium dioxide as a transparent material. Therefore, a sensitivity of a solid-state image sensor can be improved. Also, other effects are same as the first embodiment. In this description, the transparent material is defined as a material having a wavelength whose extinction coefficient is equal to or less than 0.05 in a range of a wavelength of 400 nm to 700 nm inclusive.

<Seventh embodiment>

In a seventh embodiment, an example that each of filter membranes (61a, 61b, and 61c) is composed of an oxide of amorphous silicon is described. Since other constructions are same as the first embodiment, an explanation thereof is omitted.

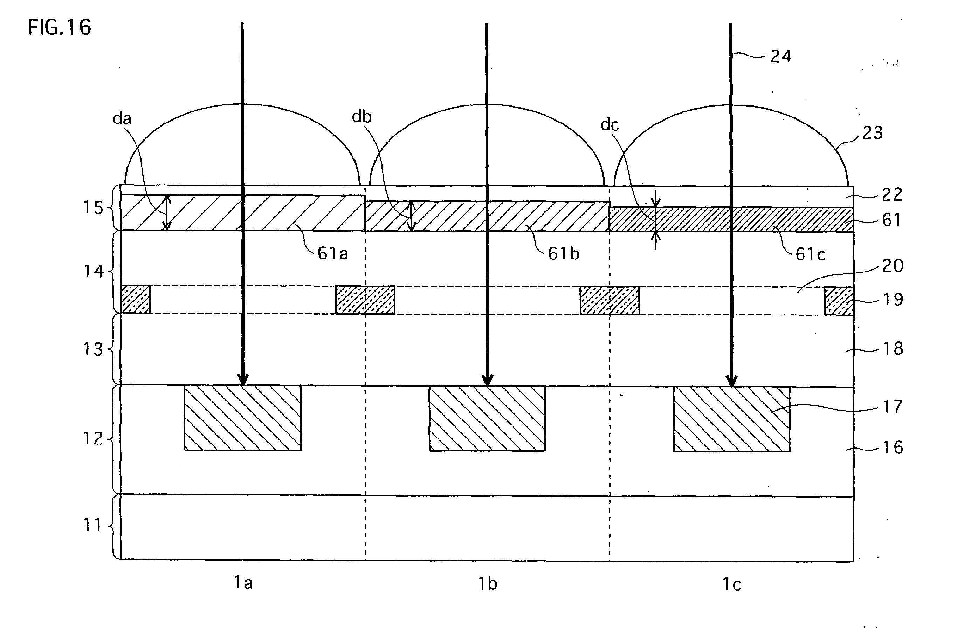

FIG. 16 is a cross section of a substrate showing a construction of pixels (1a, 1b, and 1c) of the seventh embodiment.

The seventh embodiment is different from the first embodiment in that each of the filter membranes (61a, 61b, and 61c) is composed of an oxide of amorphous silicon $SiO_x$. In addition, the seventh embodiment is different from the first embodiment in that a refractive index of each of the filter membranes (61a, 61b, and 61c) is adjusted by adjusting a composition of an oxide of amorphous silicon $SiO_x$.

An optical thickness of each of the filter membranes is smaller than a thickness equivalent to one half of a wavelength of a color to be transmitted, by a thickness corresponding to an amount of light of the color to be transmitted absorbed by amorphous silicon. This is same as the first embodiment. With this construction, it is possible that a local maximal value of a light transmittance appears at a wavelength of a color to be transmitted.

Here, a wavelength $\lambda$ of red is 650 nm, a wavelength $\lambda$ of green is 560 nm, and a wavelength $\lambda$ of blue is 490 nm. Therefore, one half of the wavelength $\lambda$ of red is 325 nm, one half of the wavelength $\lambda$ of green is 280 nm, and one half of the wavelength λ of blue is 245 nm: Since an optical thickness is smaller than a thickness equivalent to one half of a wavelength of a color to be transmitted, by a thickness corresponding to an amount of light of the color to be transmitted absorbed by amorphous silicon, an optical thickness of the red filter membrane is 315 nm, an optical thickness of the green filter membrane is 265 nm, and an optical thickness of the blue filter membrane is 235 nm. A light absorbed amount is obtained by an absorption coefficient of an oxide of amorphous silicon $SiO_x$ and an optical thickness of a filter membrane.

Refractive indexes na, nb, andnc of an oxide of amorphous silicon $SiO_x$ composing the filter membranes (61a, 61b, and 61c) are adjusted to 4.5, 4.25, and 4.0 respectively. A refractive index can be adjusted by adjusting an oxygen additive amount when an oxide of amorphous silicon $SiO_x$ is formed. Regarding $SiO_x$, the more an oxygen additive amount is, the smaller a refractive index is.

As a result, physical thicknesses (da, db, and dc) of each of the filter membranes (61a, 61b, and 61c) are da=70 nm, db=62nm, and dc=59 nm respectively. Compared the seventh embodiment with the first embodiment regarding a film thickness difference of each of the filter membranes, the film thickness difference of the seventh embodiment is smaller than the film thickness difference of the first embodiment. This is because a refractive index of each of the filter membranes is adjusted to be smaller as a wavelength of a color to be transmitted is shorter in the seventh embodiment. The smaller a film thickness difference is, the easier the planarizing layer 22 and the microlens 23 are formed.

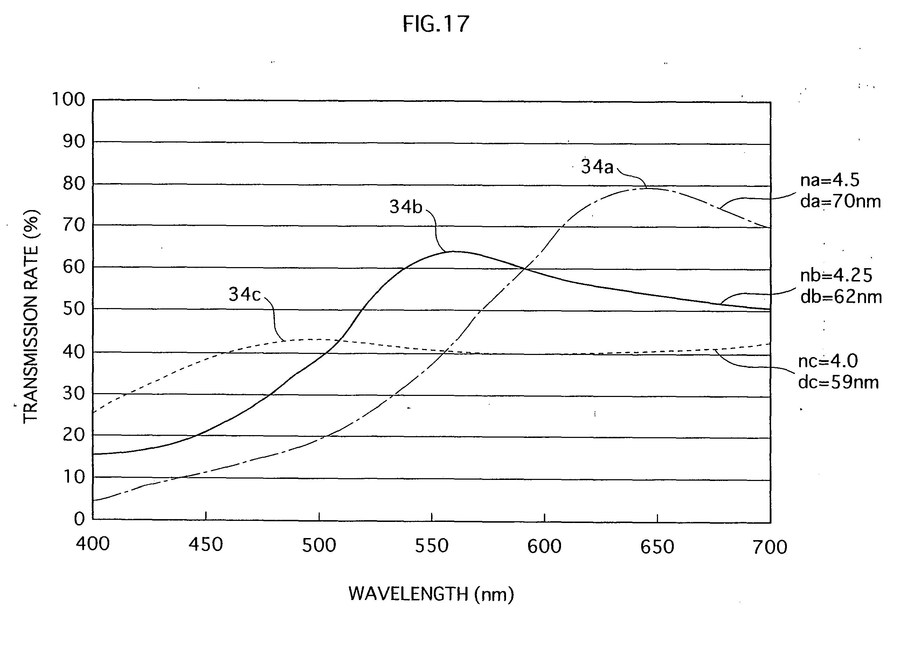

FIG. 17 shows transmission spectra of the filter membranes 61a, 61b, and 61c of the seventh embodiment.
A curved line 34a shows a transmission spectrum of the filter membrane 61a. A curved line 34b shows a transmission spectrum of the filter membrane 61b. A curved line 34c shows a transmission spectrum of the filter membrane 61c.

The filter membrane 61a has a local maximal value of a light transmittance at the red wavelength of 650nm. The filter membrane 61b has a local maximal value of a light transmittance at the green wavelength of 560nm. The filter membrane 61c has a local maximal value of a light transmittance at the blue wavelength of 490nm.
A local maximal value of a transmittance of the filter membrane 61a is 79%. A local maximal value of a transmittance of the filter membrane 61b is 64%. A local maximal value of a transmittance of the filter membrane 61c is 43%. Compared the seventh embodiment with the first embodiment regarding a transmission spectrum of the same filter membrane (for example, the curved line 34b and the curved line 31b), the local maximal value (64%) of a transmittance of the seventh embodiment is larger than the local maximal value (61%) of a transmittance of the first embodiment. It can be expected that because an absorption coefficient of an oxide of amorphous silicon $SiO_x$ is smaller than an absorption coefficient of amorphous silicon, a transmittance increases.

Note that if a film thickness difference of a filter membrane is equal to or less than 15% that is a maximum film thickness among the filter membranes (61a, 61b, and 61c), the image sensor can be easily planarized.

<Eighth embodiment>

In an eighth embodiment, an example that the antireflection film 30 is formed on a main surface of each of the filter membranes (61a, 61b, and 61c) facing a light source is described. Since other constructions are same as the seventh embodiment, an explanation thereof is omitted.

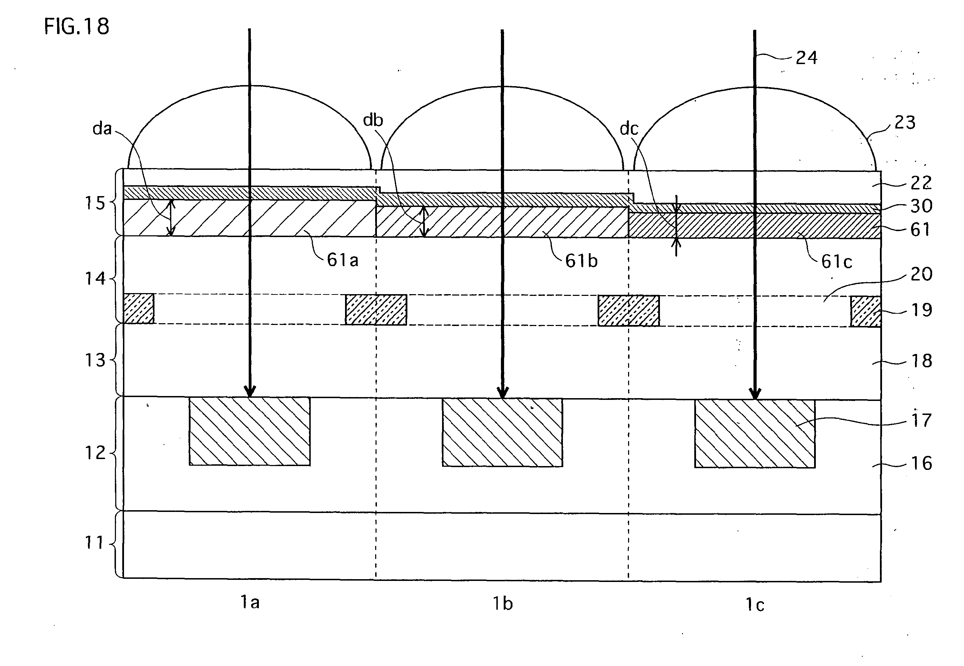

FIG. 18 is a cross section of a substrate showing a construction.of pixels (1a, 1b, and 1c) of the eighth embodiment.
The antireflection film 30 is formed on the main surface of each of the filter membranes (61a, 61b, and 61c) facing the light source. The antireflection film 30 is composed of silicon nitride and a physical thickness thereof is 50 nm. Note that physical thicknesses of each of the filter membranes 61a, 61b, and 61c are same as the seventh embodiment, and are 70 nm, 6.2 nm, and 59 nm respectively.

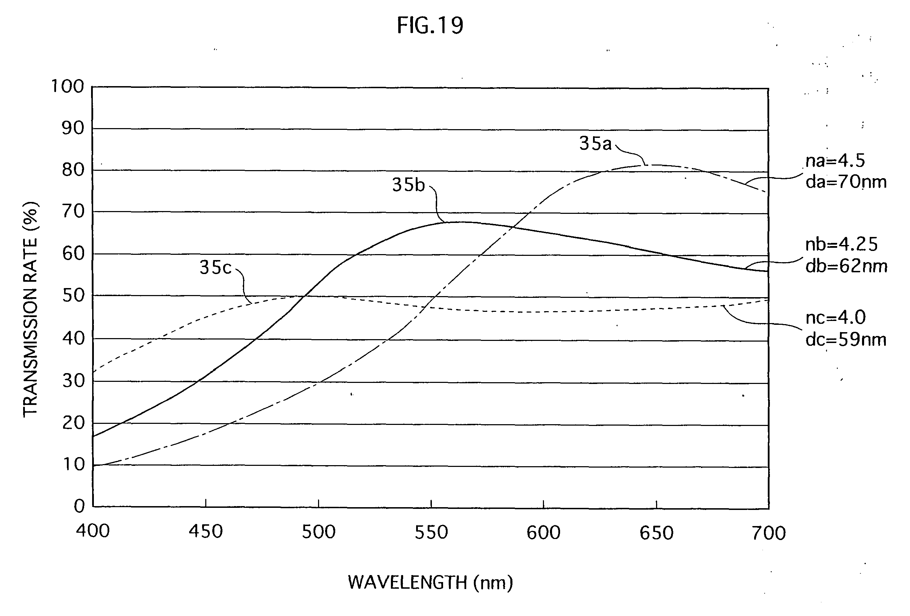

FIG. 19 shows transmission spectra of the filter membranes 61a, 61b, and 61c of the eighth embodiment. A curved line 35a shows a transmission spectrum of the filter membrane 61a. A curved line 35b shows a transmission spectrum of the filter membrane 61b. A curved line 35c shows a transmission spectrum of the filter membrane 61c.

The filter membrane 61a has a local maximal value of a light transmittance at a red wavelength of 650nm. The filter membrane 61b has a local maximal value of a light transmittance at a green wavelength of 560nm. The filter membrane 61c has a local maximal value of a light transmittance at a blue wavelength of 490nm.
Compared the eighth embodiment with the seventh embodiment regarding a transmission spectrum of the same filter membrane (for example, the filter membrane 61b: the curved line 35b and the curved line 34b), the local maximal value (67%) of a transmittance of the eighth embodiment is larger than the local maximal value (64%) of a transmittance of the seventh embodiment. This is because a light reflectance decreases by providing the antireflection film 30.

The following describes a material and a refractive index of each part in which the incident light 24 enters. Note that the refractive index indicates a value when a wavelength of the incident light is 560 nm.
Opening 20: silicon dioxide, a refractive index: 1.46
Filter membrane 61: an oxide of amorphous silicon, a refractive index: 4 to 5

Insulating layer 13: silicon dioxide, a refractive index: 1.46

Photoelectric conversion unit 17: N-type silicon, a refractive index: 4

The incident light 24 is concentrated by the microlens 23, and reached to the photoelectric conversion unit 17 through the opening 20 and each of the filter membranes (61a, 61b, and 61c). Generally, when light enters in one medium to another medium, a reflectance is determined by a ratio of a refractive indexes of two media. The following describes a reflectance R when light enters from a medium having a refractive index n1 to a medium having a refractive index n2.

$$R=((n1-n2)/(n1+n2))^2$$

When light enters from silicon dioxide (a refractive index: 1.46) that is generally used as a planarizing layer to an oxide of amorphous silicon (a refractive index: 4 to 5), a reflectance is about 25%. On the other hand, when light enters from silicon nitride (a refractive index: 2.00) to an oxide of amorphous silicon (a refractive index: 4 to 5), a reflectance is about 15%. In other words, since a reflectance decreases by 10%, a transmittance increases. As a result, a light amount that enters in the photoelectric conversion unit 17 in each of the pixels increases, and a sensitivity of the solid-state image sensor 1 is improved. This is effective as a method for preventing a sensitivity from decreasing because of the miniaturization of pixels.

By forming silicon nitride on an oxide of amorphous silicon as each of the filter membranes (61a, 61b, and 61c), there are effects of not only improving a sensitivity but also increasing the reliability and the humidity resistance of the solid-state image sensor 1.

When a reflectance decreases because the antireflection film 30 is formed on the main surface of each of the filter membranes (61a, 61b, and 61c), there is the possibility that a wavelength indicating a local maximal value of a transmittance of each of the filter membranes (61a, 61b, and 61c) shifts to a long-wavelength side. In this case, there is need to correct an optical thickness of each of the filter membranes (61a, 61b, and 61c), or a weighting factor of a transformation matrix.

<Ninth embodiment>

In a ninth embodiment, an example that the wavelength distribution of an absorption coefficient of each of filter membranes (71a, 71b, and 71c) is different is described.

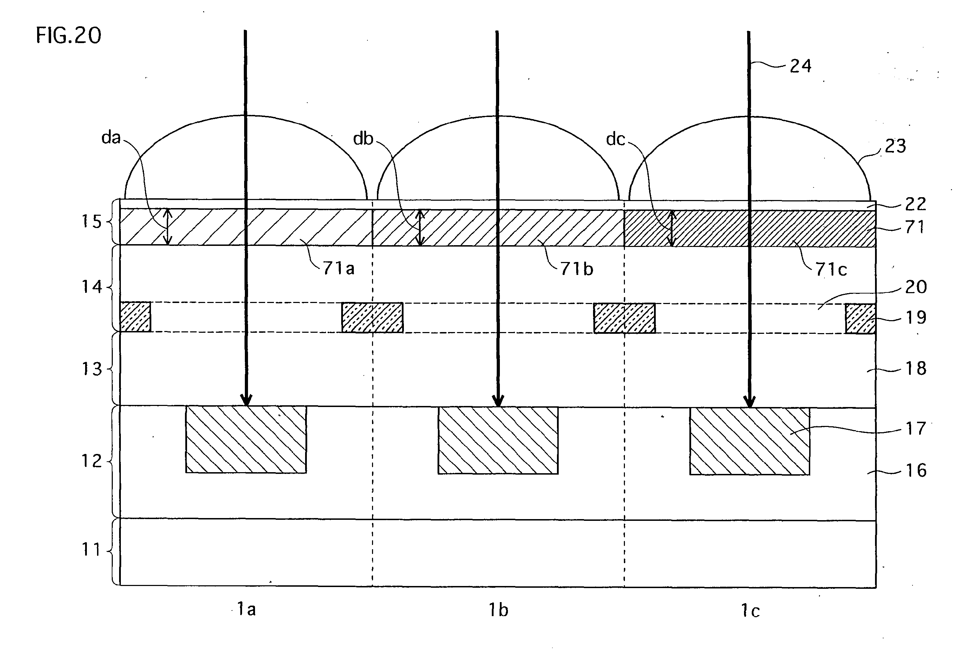

FIG. 20 is a cross section of a substrate showing a construction of pixels (1a, 1b, and 1c) of the ninth embodiment.

In the ninth embodiment, each of the filter membranes (71a, 71b, and 71c) is composed of amorphous silicon (a-Si), polysilicon (p-Si), and titanium oxide (TiO₂) respectively. In other words, a filter membrane having a shorter wavelength of a color to be transmitted is composed of an inorganic material having a smaller light absorption coefficient in an optical wavelength region. Since each of materials composing each of the filter membranes (71a, 71b, and 71c) has a different absorption coefficient in an optical wavelength region, a light transmittance varies widely.

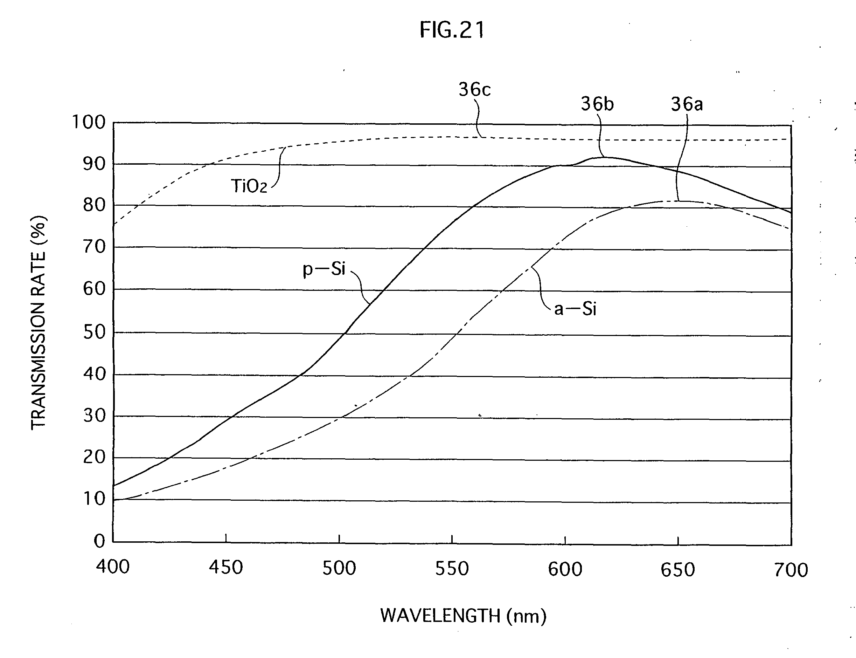

FIG. 21 shows transmission spectra of the filter membranes 71a, 71b, and 71c of the ninth embodiment. A curved line 36a shows a transmission spectrum of the filter membrane 71a. A curved line 36b shows a transmission spectrum of the filter membrane 71b. A curved line 36c shows a transmission spectrum of the filter membrane 71c.

With regard to amorphous silicon (a-Si), the wavelength distribution of a light absorption coefficient is different by controlling a growth method and a growth temperature. In other words, a transmittance to a wavelength is different, and same applies to polysilicon (p-Si) and titanium oxide (TiO₂). Therefore, as shown in FIG. 21, a transmittance varies in an optical wavelength region. By determining each of the coefficients in the transformation matrix $X_{11}$ to $X_{33}$ according to this transmission spectrum, each of signals of red, green, and blue can be obtained.

As described above, with regard to the filter membranes of the ninth embodiment, a wavelength region of transmitted light can be determined by adjusting a light absorption coefficient so as to be different according to colors.

<Tenth embodiment>

In a tenth embodiment, a manufacturing method of each of the filter membranes (61a, 61b, and 61c) will be described.

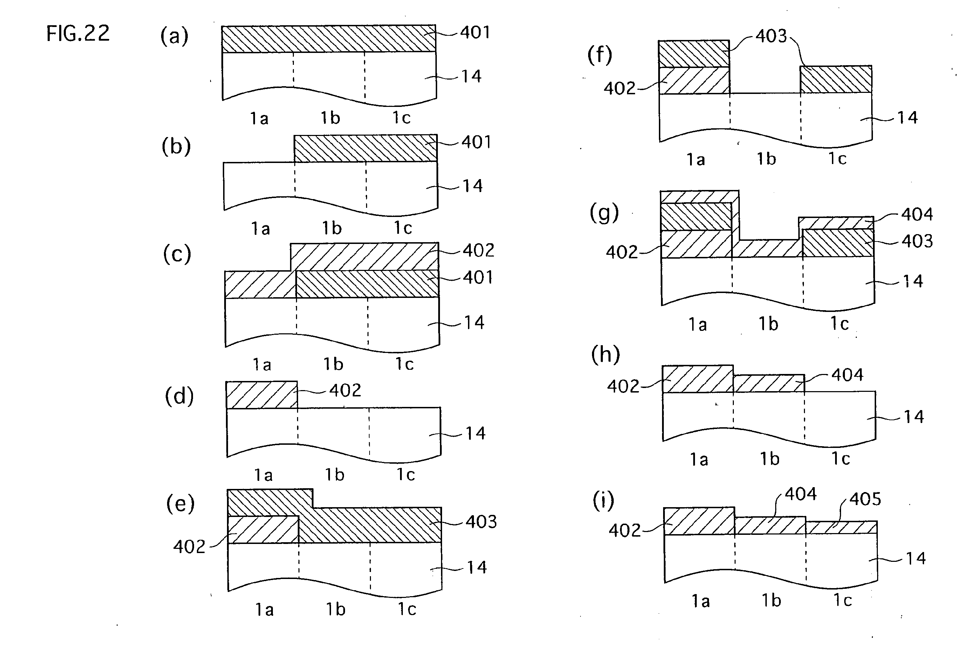

FIG. 22 is a cross section of a process showing a manufacturing method of the filter membrane 61 of the tenth embodiment.

FIG. 22 (a) shows a pixel after a first application process.

In the first application process, photoresist (PR) 401 is applied on a whole upper part of a silicon oxide film of the light shielding film forming layer 14.

FIG. 22 (b) shows a pixel after a first exposure and development process.

In the first exposure and development process, the photoresist (PR) 401 that is applied in the first application process is exposed with a certain pattern mask. Then, the exposed portion is removed and photoresist in a rest portion is cured. With this construction, only the photoresist 401 corresponding to the pixel 1a can be removed.

FIG. 22 (c) shows a pixel after a first film formation process.

In the first film formation process, an oxide of amorphous silicon 402 is formed after the first exposure and development process. With regard to an oxide of amorphous silicon, when a film is formed, a PVD (Physical Vapor Deposition) method is used. At this time, an oxygen flow rate is controlled so that the oxide of amorphous silicon 402 has a composition in which a refraction index is 4.5. A temperature of forming a film is set in a range of an ambient temperature to 400°C inclusive. When a thickness of the oxide of amorphous silicon 402 is 70 nm, the film formation is stopped.

FIG. 22 (d) shows a pixel after a first removing process.

In the first removing process, the photoresist 401 remaining in the first exposure and development process is removed. At the same time, the amorphous silicon 402 formed on the photoresist 401 is also removed.

FIG. 22 (e) shows a pixel after a second application process.

In the second application process, photoresist (PR) 403 is applied after the first removing process.

FIG. 22 (f) shows a pixel after a second exposure and development process.

In the second exposure and development process, the photoresist (PR) 403 that is applied in the second application process is exposed with a certain pattern mask. Then, the exposed portion is removed and photoresist in a rest portion is cured. With this construction, only the photoresist 403 corresponding to the pixel 1b can be removed.

FIG. 22 (g) shows a pixel after a second film formation process.

In the second film formation process, an oxide of amorphous silicon 404 is formed after the second exposure and development process. With regard to an oxide of amorphous silicon, when a film is formed, a PVD (Physical Vapor. Deposition) method is used. At this time, an oxygen flow rate is controlled so that the oxide of amorphous silicon 404 has a composition in which a refraction index is 4 . 25 . A temperature of forming a film is set in a range of an ambient temperature to 400°C inclusive. When a thickness of the oxide of amorphous silicon 404 is 62 nm, the film formation is stopped.

FIG. 22 (h) shows a pixel after a second removing process.

In the second removing process, the photoresist 403 remaining in the second exposure and development process is removed. At the same time, the amorphous silicon 404 formed on the photoresist 403 is also removed.

FIG. 22 (i) shows a pixel after a third removing process.

Following the second removing process, an oxide of amorphous silicon 405 is formed by performing the same process mentioned above. A thickness of the oxide of amorphous silicon 405 is set at 59 nm.

As described above, since a difference of each of the filter membranes is only a composition, there is no need to manage a material according to colors in a manufacturing process of a filter membrane. Therefore, the manufacturing cost of a filter membrane can be reduced.

Each of the filter membranes is formed by a semiconductor process. Therefore, the manufacturing cost of a filter membrane can be reduced.

Up to now, the solid-state image sensor of the present invention has been described specifically through the embodiments. However, the technical scope of the present invention is not limited to the above-described embodiments. The following are modifications.

(1) In the first embodiment, although the physical thicknesses (da, db, and dc) of each of the filter membranes are da=70 nm, db=55nm, and dc=40 nm respectively, the physical thicknesses are not limited to this. The physical thicknesses (da, db, and dc) just have to satisfy the following condition. The condition is that da>db>dc, 0<dc<100, 10<db<150, and 20<da<200. As a result, color separation of RGB can be realized by controlling a weighting factor of a transformation matrix.

Also, in the first embodiment, although the filter membrane 21c is used, color separation of RGB can be realized without the filter membrane 21c by controlling a weighting factor of a transformation matrix. Same applies to the sixth embodiment.

Moreover, a light transmittance can be improved by thinning each of the physical thicknesses more.

(2) In the second embodiment, the antireflection film 30 is formed on a main surface of each of the filter membranes (21a, 21b, and 21c) . If the antireflection film 30 is formed, there is the possibility that a wavelength indicating a local maximal value of a transmittance of each of the filter membranes (21a, 21b, and 21c) shifts to a long-wavelength side. In this case, there is need to correct an optical thickness of each of the filter membranes (21a, 21b, and 21c), or a weighting factor of a transformation matrix. As a result color separation can be realized properly.

(3) In the fourth embodiment, only amorphous silicon is used for a filter material . However, a filter material is not limited to amorphous silicon, and polysilicon, single-crystal silicon, or a material mainly containing silicon can be used. Same applies to the fifth embodiment.

(4) In the sixth embodiment, although titanium dioxide is used as a transparent material composing a filter membrane, the transparent material is not limited to this. For example, tantalum oxide (tantalum pentoxide and the like) or niobium oxide (niobium pentoxide and the like) can be used in order to realize a solid-state image sensor having a high sensitivity.

(5) In the sixth embodiment, an antireflection film may be formed on the main surface of each of the filter membrane (51a, 51b, and 51c) . This can improve much higher sensitivity of a solid-state image sensor. As a material of an antireflection film, silicon nitride, silicon oxide nitride, silicon oxide and the like may be used.

When a reflectance decreases because the antireflection film is formed on the main surface of each of the filter membrane (51a, 51b, and 51c), there is the possibility that a wavelength indicating a local maximal value of a transmittance of each of the filter membrane (51a, 51b, and 51c) shifts to a long-wavelength side. In this case, there is need to correct an optical thickness of each of the filter membrane (51a, 51b, and 51c), or a weighting factor of a transformation matrix. (6) In the sixth embodiment, although the physical thicknesses (da, db, and dc) of each of the filter membranes are da=125 nm, db=105nm, and dc=90 nm respectively, the physical thicknesses are not limited to this. The physical thicknesses (da, db, and dc) just have to satisfy the following condition. The condition is that da>db>dc, 0<dc<200, 50<db<250, and 75<da<300. As a result, color separation of RGB can be realized by controlling a weighting factor of a transformation matrix. (7) In the embodiments, only a characteristic of a color filter in an optical wavelength region is indicated. However, light having a different band may be transmitted in a wavelength region such as an infrared region, an ultraviolet region, and the like by varying a thickness of a color filter properly. (8) In the embodiments, an optical thickness of each of the is smaller than a thickness equivalent to one half of a wavelength of a color to be transmitted, by a thickness corresponding to an amount of light of the color to be transmitted absorbed by an inorganic material. When a filter membrane is used for a color image sensor, a range of the optical thickness is 150 nm to 400 nm inclusive.

**Industrial Applicability**

The solid-state image sensor of the present invention can be used as a solid- state image sensor of a digital camera, a video camera, and the like.

**Claims**

1. A solid-state image sensor having a plurality of pixels, wherein
each of the plurality of pixels includes a filter membrane for transmitting light of a predetermined color, and a photoelectric conversion unit for converting the light transmitted through the filter membrane into a charge;
the filter membrane is a single layer film composed of an inorganic material; and
an optical thickness of the single layer film is smaller than a thickness equivalent to one half of a wavelength of the predetermined color, by a thickness corresponding to an amount of the light of the predetermined color absorbed by the inorganic material.

2. The solid-state image sensor of Claim 1, wherein the larger an absorption coefficient of the inorganic material at a light wavelength of the predetermined color is, the smaller the optical thickness of the single layer film is.

3. The solid-state image sensor of Claim 1, wherein a composition of the inorganic material is identical for the plurality of pixels.

4. The solid-state image sensor of Claim 1, wherein a composition of the inorganic material is different according to which of a plurality of colors is to be transmitted; and
the shorter a wavelength of each of the colors is, the smaller a refractive index of the inorganic material is.

5. The solid-state image sensor of Claim 1, wherein a refractive index of the inorganic material is equal to or larger than 3.

6. The solid-state image sensor of Claim 1, wherein the inorganic material is amorphous silicon, polysilicon, single-crystal silicon, or a material mainly containing silicon.

7. The solid-state image sensor of Claim 1, wherein the inorganic material is titanium oxide, tantalum oxide, or niobium oxide.

8. The solid-state image sensor of Claim 1, wherein each of the plurality of pixels further includes an antireflection film that is provided on a main surface of the filter membrane facing a light source and has a smaller refractive index than the filter membrane.

9. The solid-state image sensor of Claim 8, wherein the antireflection film is composed of silicon nitride, silicon dioxide, or silicon oxide nitride.

10. The solid-state image sensor of Claim 1, wherein the photoelectric conversion unit is formed in a part of a substrate;
each of the plurality of pixels further includes a light shielding film that covers the substrate and has an opening provided in a position corresponding to the photoelectric conversion unit; and
the filter membrane is provided between the light shielding film and the substrate.

11. The solid-state image sensor of Claim 1, wherein each of the plurality of pixels is provided so that a main surface of the filter membrane facing the photoelectric conversion unit is provided on a same plane;
each of the plurality of pixels further includes a planarizing layer provided on a main surface of the filter membrane facing a light source; and
the larger a physical thickness of the filter membrane is, the smaller a thickness of the planarizing layer is.

**12.** The solid-state image sensor of Claim 11, wherein each of the plurality of pixels further includes a microlens provided on a main surface of the planarizing layer facing the light source.

**13.** A solid-state image sensor having a plurality of pixels, wherein
each of the plurality of pixels includes a filter membrane for transmitting light of a predetermined color, and a photoelectric conversion unit for converting the light transmitted through the filter membrane into a charge;
the filter membrane is a single layer film composed of an inorganic material; and
an optical thickness of the single layer film is set according to which of a plurality of colors is to be transmitted in a range of 150 nm to 400 nm inclusive.

**14.** A solid-state image sensor having a plurality of pixels, wherein
each of the plurality of pixels includes a filter membrane for transmitting light of a predetermined color, and a photoelectric conversion unit for converting the light transmitted through the filter membrane into a charge;
the shorter a wavelength of the predetermined color is, the smaller a light absorption coefficient in an optical wavelength region of an inorganic material composing the filter membrane is.

**15.** The solid-state image sensor of Claim 14, wherein the light absorption coefficient of the filter membrane is different by varying a composition of the inorganic material.

**16.** The solid-state image sensor of Claim 14, wherein an optical thickness of the filter membrane is smaller than a thickness equivalent to one half of a wavelength of the predetermined color, by a thickness corresponding to an amount of the light of the predetermined color absorbed by the inorganic material

FIG.1

FIG.1 — Block diagram showing pixel array (1, 1a, 1b, 1c) with R, RG, RGB pixels, VERTICAL SCANNING CIRCUIT (3), HORIZONTAL SCANNING CIRCUIT (4), DRIVE CIRCUIT (2), ANALOG FRONT END (5), SIGNAL PROCESSING CIRCUIT (6), WORKING MEMORY (7), RECORDING MEMORY (8), and CONTROL UNIT (9).

FIG.2

EP 1 816 677 A1

FIG.3

EP 1 816 677 A1

## FIG.4

SIGNAL PROCESSING CIRCUIT — 6

TRANSFORMATION MATRIX RETENTIVE UNIT — 61

OPERATION UNIT — 62

MEMORY CONTROL UNIT — 63

ANALOG FRONT END — 5

WORKING MEMORY — 7

RECORDING MEMORY — 8

CONTROL UNIT — 9

EP 1 816 677 A1

## FIG.5A

$$\begin{bmatrix} Sa \\ Sb \\ Sc \end{bmatrix} = \begin{bmatrix} W_{11} & W_{12} & W_{13} \\ W_{21} & W_{22} & W_{23} \\ W_{31} & W_{32} & W_{33} \end{bmatrix} \begin{bmatrix} B \\ G \\ R \end{bmatrix}$$

## FIG.5B

$$\begin{bmatrix} B \\ G \\ R \end{bmatrix} = \begin{bmatrix} X_{11} & X_{12} & X_{13} \\ X_{21} & X_{22} & X_{23} \\ X_{31} & X_{32} & X_{33} \end{bmatrix} \begin{bmatrix} Sa \\ Sb \\ Sc \end{bmatrix}$$

# FIG.6

EP 1 816 677 A1

FIG.7

EP 1 816 677 A1

FIG.8

EP 1 816 677 A1

# FIG.9

FIG.10

(a)

(b)

(c)

(d)

(e)

(f)

(g)

(h)

EP 1 816 677 A1

FIG.11

21

FIG.12

(a)

(b)

(c)

(d)

(e)

(f)

(g)

(h)

(i)

EP 1 816 677 A1

FIG.13

<u>21</u>

211
303
211
301
211
305

EP 1 816 677 A1

FIG.14

EP 1 816 677 A1

# FIG.15

EP 1 816 677 A1

FIG.16

EP 1 816 677 A1

## FIG.17

EP 1 816 677 A1

FIG.18

EP 1 816 677 A1

# FIG.19

FIG.20

EP 1 816 677 A1

# FIG.21

EP 1 816 677 A1

FIG.22

(a)

(b)

(c)

(d)

(e)

(f)

(g)

(h)

(i)

EP 1 816 677 A1

## INTERNATIONAL SEARCH REPORT

| | International application No. |
|---|---|
| | PCT/JP2005/016414 |

| A. CLASSIFICATION OF SUBJECT MATTER |
|---|
| *H01L27/14* (2006.01), *G03B11/00* (2006.01) |

According to International Patent Classification (IPC) or to both national classification and IPC

| B. FIELDS SEARCHED |
|---|
| Minimum documentation searched (classification system followed by classification symbols) |
| *H01L27/14* (2006.01), *H04N5/335* (2006.01), *G02B5/20* (2006.01) |

Documentation searched other than minimum documentation to the extent that such documents are included in the fields searched
Jitsuyo Shinan Koho        1922-1996   Jitsuyo Shinan Toroku Koho   1996-2005
Kokai Jitsuyo Shinan Koho  1971-2005   Toroku Jitsuyo Shinan Koho   1994-2005

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| A | JP 8-5821 A  (Industrial Technology Research Institute), 12 January, 1996 (12.01.96), Par. Nos. [0003] to [0005] (Family: none) | 1-16 |
| A | JP 63-62867 A  (Seikosha Co., Ltd.), 19 March, 1988 (19.03.88), Full text & US 4887886 A          & DE 3728837 C & GB 2196021 B          & CH 680324 A | 1-16 |
| A | JP 62-223702 A  (Toshiba Corp.), 01 October, 1987 (01.10.87), Full text (Family: none) | 1-16 |

☒  Further documents are listed in the continuation of Box C.          ☐  See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 02 December, 2005 (02.12.05) | 13 December, 2005 (13.12.05) |

| Name and mailing address of the ISA/ | Authorized officer |
|---|---|
| Japanese Patent Office | |
| Facsimile No. | Telephone No. |

Form PCT/ISA/210 (second sheet) (April 2005)

## INTERNATIONAL SEARCH REPORT

| | International application No. |
|---|---|
| | PCT/JP2005/016414 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 59-81624 A  (Stanley Electric Co., Ltd.),<br>11 May, 1984 (11.05.84),<br>Full text<br>(Family: none) | 1-16 |
| P,A | JP 2004-272010 A  (Sony Corp.),<br>30 September, 2004 (30.09.04),<br>Full text<br>(Family: none) | 1-16 |
| P,X | JP 2005-175430 A  (Matsushita Electric<br>Industrial Co., Ltd.), | 1-6,8-16 |
| P,A | 30 June, 2005 (30.06.05),<br>Full text<br>& US 2005/103983 A1 | 7 |

Form PCT/ISA/210 (continuation of second sheet) (April 2005)

**REFERENCES CITED IN THE DESCRIPTION**

**Patent documents cited in the description**

- JP H056986 B

- JP H07311310 B